# EUROPEAN PATENT SPECIFICATION

(11) **EP 1 428 256 B1**
(45) Date of publication and mention of the grant of the patent: **22.03.2006**
(21) Application number: 02761321.5
(22) Date of filing: 12.08.2002
(51) Int. Cl.: H01L 23/48

(54) **SEMICONDUCTOR DEVICE WITH COMPLIANT ELECTRICAL TERMINALS, APPARATUS INCLUDING THE SEMICONDUCTOR DEVICE, AND METHODS FOR FORMING SAME**
HALBLEITERANORDNUNG MIT WEICHEN ELEKTRISCHEN ANSCHLÜSSEN, BAUTEIL DAMIT UND SEINE HERSTELLUNGSVERFAHREN
DISPOSITIF A SEMI-CONDUCTEUR COMPORTANT DES BORNES ELECTRIQUES SOUPLES, APPAREIL EQUIPE DE CE DISPOSITIF A SEMI-CONDUCTEUR ET PROCEDES DE FABRICATION CORRESPONDANTS

(30) Priority: 12.09.2001 US 952337
(43) Date of publication of application: 16.06.2004
(73) Proprietor: DOW CORNING CORPORATION, Midland, Michigan 48611 (US)
(72) Inventor: LUTZ, Michael, A., Hope, MI 48628 (US)
(74) Representative: Nash, David Allan
(86) International application number: PCT/US2002/025427
(87) International publication number: WO 2003/023855

(56) References cited:
- US-A- 5 074 947
- US-A- 5 937 320
- US-A- 6 114 187
- US-B1- 6 181 569
- US-B1- 6 271 107

## Description

### BACKGROUND OF THE INVENTION

### 1. FIELD OF THE INVENTION

This invention relates generally to electrical apparatus having terminals, and, more particularly, to electrical apparatus having area array terminals for forming electrical connections.

### 3. DESCRIPTION OF THE RELATED ART

During manufacture of an integrated circuit, signal lines that are formed upon a silicon substrate and which are to be ultimately connected to external devices, are terminated at flat metal contact regions called input/output (I/O) pads. Following manufacture, the integrated circuit (i.e., chip) is typically secured within a protective semiconductor device package. Each I/O pad of the integrated circuit is then connected to one or more electrical terminals of the device package.

The electrical terminals of a device package are typically arranged either about a periphery of the package, or in a two-dimensional array across an underside surface of the package. Metal conductors are typically used to connect the I/O pads of the integrated circuit to the terminals of the device package. The metal conductors may be, for example, fine metal bond wires, "traces" (i.e., signal lines) formed on and/or within a substrate of the device package, traces formed on and/or within a flexible carrier film or laminate such as a tape automated bonding or TAB tape, or a lead frame. Peripheral terminal device packages may have, for example, terminals called "pins" for insertion into holes in an interconnect apparatus (e.g., a printed circuit board or PCB), or terminals called "leads" for attachment to flat metal contact regions on an exposed surface of an interconnect apparatus. Area array terminal device packages typically have solder "balls" or "bumps" for attachment to flat metal pads on an exposed surface of an interconnect apparatus.

Area array terminal packages have terminals arranged in a two-dimensional array across the underside surface of the device package. As a result, the physical dimensions of area array terminal packages having hundreds of terminals are much smaller than their peripheral terminal counterparts. Such smaller packages are highly desirable in portable device applications such as laptop and palmtop computers and hand-held communications devices such as cellular telephones. In addition, the lengths of signal lines from integrated circuit I/O pads to device package terminals are shorter, thus the high frequency electrical performances of grid array device packages are typically better than those of corresponding peripheral terminal device packages.

Controlled collapse chip connection (C4) is a well known method of attaching an integrated circuit directly to a substrate (e.g., fiberglass-epoxy printed circuit board material or a ceramic substrate). The C4 attachment method is commonly referred to as the "flip chip" attachment method. In preparation for C4 attachment, the I/O pads of the integrated circuit are typically arranged in a two-dimensional array upon an underside surface of the integrated circuit, and a corresponding set of bonding pads are formed upon an upper surface of the substrate. A solder "bump" is formed upon each of the I/O pads of the integrated circuit. For example, several layers of constituent metals of a solder alloy may be deposited on the I/O pads of the integrated circuit. Following deposition of the metal layers, the integrated circuit may be heated to melt the metal layers. The molten metals may mix together to form the solder alloy, and the surface tension of the solder alloy may cause the molten solder alloy to form hemispherical solder "bumps" on the I/O pads of the integrated circuit. Solder paste is typically deposited upon each of the bonding pads of the substrate.

During C4 attachment of the integrated circuit to the substrate, the solder bumps on the I/O pads of the integrated circuit are placed in physical contact with the solder paste on the corresponding bonding pads of the substrate. The substrate and the integrated circuit are then heated long enough for the solder to melt or "reflow." When the solder cools, the I/O pads of the integrated circuit are electrically and mechanically coupled to the bonding pads of the substrate.

A popular type of area array terminal device package is the "flip chip" ball grid array (BGA) device package. A typical "flip chip" BGA device package includes an integrated circuit mounted upon an upper surface of a larger package substrate using the C4 or "flip chip" attachment method described above. The substrate includes two sets of bonding pads: a first set arranged on the upper surface adjacent to the integrated circuit, and a second set arranged in a two-dimensional array across an underside surface of the BGA device package. One or more layers of electrically conductive traces (i.e., signal lines) formed on and/or within the substrate connect respective members of the first and second sets of bonding pads. Members of the second set of bonding pads function as device package terminals. A solder ball is attached to each member of the second set of bonding pads. The solder balls allow the BGA device package to be surface mounted to an interconnect apparatus (e.g., a PCB).

A problem arises in that the coefficients of thermal expansion (CTEs) of the integrated circuit and the package substrate typically differ. This difference in CTEs creates mechanical stresses within the solder bumps during the solder reflow operation described above. Further, following attachment of the integrated circuit to the package substrate, the integrated circuit heats up while dissipating electrical power during operation, and cools down when not operating. Again, the difference in the CTEs of the integrated circuit and the package substrate creates mechanical stresses within the solder bumps during the resultant thermal cycling. Left unchecked, these mechanical stresses typically cause the solder bump connections to fatigue and fail after an unacceptably small number of thermal cycles.

A common solution to the above described CTE mismatch problem is to form a layer of an underfill material in the region between the integrated circuit and the substrate during a final portion of the "flip chip" attachment process. The underfill material encapsulates the C4 connections and mechanically "locks" the chip to the substrate, reducing mechanical stresses in the solder bump connections during thermal cycling, thereby significantly increasing the reliabilities of the solder bump connections. It is noted, however, that using an underfill material to reduce solder bump stresses creates another problem in that rework of such underfilled integrated circuit device packages is very difficult. In addition, the underfill process is time consuming, and constitutes a process the semiconductor device manufacturing industry would like to eliminate.

The term "chip scale package" or CSP is used to describe a BGA device package that has dimensions no larger than 1.2 times corresponding dimensions of the integrated circuit. Due to their smaller size, CSPs are attractive, particularly for portable device applications. The substrate of a CSP may be, for example, a flexible film or laminate (e.g., polyimide film/laminate), a rigid material (e.g., fiberglass-epoxy printed circuit board material or ceramic), or a lead frame.

Unlike larger BGA device packages, a solder bump, not a solder ball, is formed on each member of the second set of bonding pads of the CSP substrate (e.g., in a manner similar to the way in which solder bumps are formed upon the I/O pads of the integrated circuit). The solder bumps of CSPs allow the CSPs to be surface mounted to an interconnect apparatus (e.g., a PCB). Where the CTE mismatch between the CSP substrate and the interconnect apparatus is relatively small, the solder bump connections formed between the CSP and the interconnect apparatus are sufficiently reliable that there is often no requirement to fill the region between the CSP substrate and the interconnect apparatus with an underfill material. In this situation, it is relatively easy to remove a faulty CSP from the interconnect apparatus and replace the faulty. CSP with another CSP (i.e., rework the CSP).

In some cases, however, a CSP is formed by merely forming a thin protective coating over the underside surface of an integrated circuit about the I/O pads, and forming solder bumps upon the I/O pads. In this case, when the CSP is surface mounted to an interconnect apparatus (e.g., a PCB), there is no CSP substrate between the integrated circuit substrate and the interconnect apparatus. In this situation, the mechanical stresses within the solder bumps, created during temperature cycling due to the CTE mismatch between the integrated circuit and the interconnect apparatus, cause the solder bump connections to fatigue and fail after an unacceptably small number of thermal cycles.

In US 5,074,947 a method is presented for interconnecting bond pads of a flip chip with bond pads of a substrate by an electrically conductive polymer. An organic protective layer is selectively formed over a surface of a flip chip to thereby leave exposed bond pads on the flip chip. Electrically conductive polymerizable precursor is formed on the bond pads extending to a level beyond the organic protective layer to form bumps. The bumps are aligned with bond pads of a substrate and then contacted to those bond pads. The bumps can be polymerized either before or after contacting the bumps to the bond pads of the substrate to form electrically conductive interconnections between the bond pads of the flip chip and the bond pads of the substrate.

The present invention is directed to an integrated circuit device with compliant electrical terminals, wherein the compliant electrical terminals achieve highly reliable electrical connections between the integrated circuit device and an interconnect apparatus (e.g., a PCB) to which the integrated circuit device is attached, despite a CTE mismatch between the integrated circuit device and the interconnect apparatus, and without the required use of an underfill material.

### SUMMARY OF THE INVENTION

A semiconductor device is described including multiple input/output (I/O) pads arranged on a surface of a semiconductor substrate, a compliant dielectric layer, an outer dielectric layer, and multiple electrically conductive, compliant interconnect bumps (i.e., compliant bumps). The semiconductor device may be, for example, a chip scale package (CSP). The compliant bumps may form electrical terminals of the semiconductor device.

The compliant dielectric layer is positioned between the outer dielectric layer and the surface of the semiconductor substrate. The outer dielectric layer and the compliant dielectric both have multiple openings (i.e., holes) extending therethrough. Each of the compliant bumps is formed upon, and corresponds to, a different one of the I/O pads, and extends through a different one of the openings in the first compliant dielectric layer and the outer dielectric layer.

Each of the compliant bumps includes an electrically conductive, compliant body, and an electrically conductive, solderable conductor element. The compliant bodies are positioned between the solderable conductor elements and corresponding I/O pads. The compliant bodies form mechanically flexible, electrically conductive paths between the solderable conductor elements and the corresponding I/O pads.

Each of the solderable conductor elements is solder wettable. That is, molten solder coming in contact with exposed surfaces of the solderable conductor elements will adhere to those surfaces, thus allowing solder to be used to electrically and mechanically couple the solderable conductor elements to corresponding bonding pads of an element to which the semiconductor device is to be connected (i.e., a connected element).

The compliant bodies allow the compliant bumps to deform elastically under forces below a threshold value. As a result, the compliant bumps are able to withstand such forces without the fatigue and failure typical of solder bump connections. For this reason, the reliabilities of connections formed between the semiconductor device and the connected element using the compliant bumps are expectedly greater than the reliabilities of solder bump connections.

The compliant dielectric layer may provide stress relief for the outer dielectric layer and the surface of the semiconductor substrate. When a force is applied to a surface of the outer dielectric layer opposite the compliant dielectric layer, the force may be substantially transmitted to the compliant dielectric layer. In response to the force, the compliant dielectric layer deforms, allowing the outer dielectric layer to move in relation to the surface of the semiconductor substrate.

The outer dielectric layer may provide mechanical protection for the compliant dielectric layer and the surface of the semiconductor substrate. When the force is applied to the surface of the outer dielectric layer opposite the compliant dielectric layer, the outer dielectric layer deforms to a lesser extent than the compliant dielectric layer, and serves to distribute the force over a relatively wide area of the compliant dielectric layer.

One embodiment of a method for forming the semiconductor device includes forming the compliant dielectric layer over the surface of the semiconductor substrate. Each of the multiple openings of the compliant dielectric layer exposes a different one of the I/O pads. One of the compliant bodies is formed in each of the openings of the compliant dielectric layer such that each of the compliant bodies is electrically coupled to the I/O pad exposed by the corresponding opening. The outer dielectric layer is formed over the compliant dielectric layer. Each of the openings of the outer dielectric layer exposes a different one of the compliant bodies. One of the solderable conductor elements is formed in each of the openings of the outer dielectric layer such that each of the solderable conductor elements is electrically coupled to the compliant body exposed by the corresponding opening. Several other embodiments of the method for forming the semiconductor device are described.

An apparatus is described including a component (e.g., a printed circuit board, a package substrate, etc.) joined to a semiconductor device (e.g., the semiconductor device described above). The component includes a substrate and multiple bonding pads arranged upon a surface of the substrate, wherein the bonding pads are arranged according to a first pattern. The semiconductor device includes a semiconductor substrate and multiple input/output (I/O) pads arranged on a surface of the semiconductor substrate, wherein the I/O pads are arranged according to a second pattern, and wherein the second pattern is substantially the same as (e.g., a mirror image of) the first pattern.

The semiconductor device also includes a compliant dielectric layer, an outer dielectric layer, and multiple copies of the electrically conductive, compliant bumps described above. The compliant dielectric layer is positioned between the outer dielectric layer and the surface of the semiconductor substrate. The compliant dielectric layer and the outer dielectric layer each have multiple openings (i.e., holes) extending therethrough. Each of the compliant bumps extends through a different one of the openings in the compliant dielectric layer and the outer dielectric layer. In the apparatus, the bonding pads of the component are adjacent to, and electrically coupled to, the I/O pads of the semiconductor device.

One embodiment of a method for forming the apparatus described above includes providing the component and the semiconductor device. Solder bumps are formed on the bonding pads of the component. The I/O pads of the semiconductor device are brought into contact with the solder bumps formed on the bonding pads of the component. The substrate of the component and/or the semiconductor substrate of the semiconductor device are heated until the solder bumps melt. When the solder cools, the I/O pads of the semiconductor device are mechanically and electrically coupled to the bonding pads of the component.

### BRIEF DESCRIPTION OF THE DRAWINGS

The invention may be understood by reference to the following description taken in conjunction with the accompanying drawings, in which like reference numerals identify similar elements, and in which:
Figure I is a perspective view of a portion of one embodiment of a semiconductor device including a semiconductor substrate, a compliant dielectric layer, an outer dielectric layer, and multiple electrically conductive, compliant interconnect bumps (i.e., compliant bumps) extending through openings (i.e., holes) in the compliant dielectric layer and the outer dielectric layer;
Figure 2A is a cross-sectional view of a portion of the substrate of Figure 1, wherein multiple input/output (I/O) pads have been formed on an upper surface of the substrate;
Figure 2B is the cross-sectional view of the portion of the substrate of Figure 2A, wherein the compliant dielectric layer of Figure I has been formed over the upper surface of the substrate, and wherein the compliant dielectric layer has multiple holes extending therethrough, and wherein each of the holes exposes an upper surface of a different one of the I/O pads;
Figure 2C is the cross-sectional view of the portion of the substrate of Figure 2B, wherein electrically conductive, compliant bodies have been formed in the holes of the compliant dielectric layer;
Figure 2D is the cross-sectional view of the portion of the substrate 102 of Figure 2C, wherein the outer dielectric layer of Figure 1 has been formed over an upper surface of the compliant dielectric layer, and wherein the outer dielectric layer has multiple holes extending therethrough, and wherein each of the holes exposes an upper surface of a different one of the compliant bodies;
Figure 2E is the cross-sectional view of the portion of the substrate of Figure 2D, wherein electrically conductive, solderable conductor elements have been formed in the holes of the outer dielectric layer;
Figure 3A is a cross-sectional view of a portion of the substrate of Figure 1, wherein the multiple I/O pads of Figure 2A have been formed on the upper surface of the substrate;
Figure 3B is the cross-sectional view of the portion of the substrate of Figure 3A, wherein electrically conductive metal coating elements have been formed over upper and side surfaces of the I/O pads;
Figure 3C is the cross-sectional view of the portion of the substrate of Figure 3B, wherein the compliant dielectric layer of Figure 1 has been formed over the conductive metal coating elements and the portion of the upper surface of the semiconductor substrate surrounding the conductive metal coating elements, and wherein the compliant dielectric layer has multiple holes extending therethrough, and wherein each of the holes exposes an upper surface of a different one of the conductive metal coating elements;
Figure 3D is the cross-sectional view of the portion of the substrate of Figure 3C, wherein the electrically conductive, compliant bodies of Figure 2C have been formed in the holes of the compliant dielectric layer;
Figure 3E is the cross-sectional view of the portion of the substrate of Figure 3D, wherein the outer dielectric layer of Figure 1 has been formed over an upper surface of the compliant dielectric layer, and wherein the outer dielectric layer has multiple holes extending therethrough, and wherein each of the holes exposes an upper surface of a different one of the compliant bodies;
Figure 3F is the cross-sectional view of the portion of the substrate of Figure 3E, wherein the electrically conductive, solderable conductor elements of Figure 2E have been formed in the holes of the outer dielectric layer;
Figure 4A is a cross-sectional view of a portion of the substrate of Figure 1, wherein the multiple I/O pads of Figure 2A have been formed on the upper surface of the substrate;
Figure 4B is the cross-sectional view of the portion of the substrate of Figure 4A, wherein the compliant dielectric layer of Figure 2B has been formed over the upper surface of the substrate, and wherein the compliant dielectric layer has multiple holes extending therethrough, and wherein each of the holes exposes an upper surface of a different one of the I/O pads;
Figure 4C is the cross-sectional view of the portion of the substrate of Figure 4B, wherein the compliant bodies of Figure 2C have been formed in the holes of the compliant dielectric layer;
Figure 4D is the cross-sectional view of the portion of the substrate of Figure 4C, wherein electrically conductive metal coating elements have been formed over upper surfaces of the compliant bodies;
Figure 4E is the cross-sectional view of the portion of the substrate of Figure 4D, wherein the outer dielectric layer of Figure 1 has been formed over an upper surface of the compliant dielectric layer, and wherein the outer dielectric layer has multiple holes extending therethrough, and wherein each of the holes exposes an upper surface of a different one of the conductive metal coating elements;
Figure 4F is the cross-sectional view of the portion of the substrate of Figure 4E, wherein the solderable conductor elements of Figure 2E have been formed in the holes of the outer dielectric layer;
Figure 5A is a cross-sectional view of a portion of the substrate of Figure 1, wherein the multiple I/O pads of Figure 2A have been formed on the upper surface of the substrate;
Figure 5B is the cross-sectional view of the portion of the substrate of Figure 5A, wherein the conductive metal coating elements of Figure 3B have been formed over upper and side surfaces of the I/O pads;
Figure 5C is the cross-sectional view of the portion of the substrate of Figure 5B, wherein the compliant dielectric layer of Figure 2B has been formed over the upper surface of the substrate, and wherein the compliant dielectric layer has multiple holes extending therethrough, and wherein each of the holes exposes an upper surface of a different one of the conductive metal coating elements of Figure 3B;
Figure 5D is the cross-sectional view of the portion of the substrate of Figure 5C, wherein the compliant bodies of Figure 2C have been formed in the holes of the compliant dielectric layer;
Figure 5E is the cross-sectional view of the portion of the substrate of Figure 5D, wherein the electrically conductive metal coating elements of Figure 4D have been formed over upper surfaces of the compliant bodies;
Figure 5F is the cross-sectional view of the portion of the substrate of Figure 5E, wherein the outer dielectric layer of Figure 1 has been formed over an upper surface of the compliant dielectric layer, and wherein the outer dielectric layer has multiple holes extending therethrough, and wherein each of the holes exposes an upper surface of a different one of the conductive metal coating elements of Figure 4D;
Figure 5G is the cross-sectional view of the portion of the substrate of Figure 5F, wherein the solderable conductor elements of Figure 2E have been formed in the holes of the outer dielectric layer;
Figure 6A is a cross-sectional view of a portion of a first apparatus, wherein the first apparatus includes a substrate and multiple bonding pads arranged upon a surface of the substrate;
Figure 6B is the cross-sectional view of the portion of the first apparatus of Figure 6A, wherein solder coating layers have been formed on upper surfaces of the bonding pads;
Figure 6C is a cross-sectional view of a portion of one embodiment of the semiconductor device of Figure 1 and the portion of the first apparatus of Figure 6B, wherein the portion of the semiconductor device has been inverted and positioned over the portion of the first apparatus, and wherein a coupling operation is taking place wherein the semiconductor device is being coupled to the first apparatus; and
Figure 6D is a cross-sectional view of the portions of the semiconductor device and the first apparatus of Figure 6B following the coupling operation of Figure 6C, wherein the portions of the semiconductor device and the first apparatus have been joined to form a second apparatus.

While the invention is susceptible to various modifications and alternative forms, specific embodiments thereof have been shown by way of example in the drawings and are herein described in detail. It should be understood, however, that the description herein of specific embodiments is not intended to limit the invention to the particular forms disclosed, but on the contrary, the intention is to cover all modifications, equivalents, and alternatives falling within the spirit and scope of the invention as defined by the appended claims.

### DETAILED DESCRIPTION OF SPECIFIC EMBODIMENTS

Illustrative embodiments of the invention are described below. In the interest of clarity, not all features of an actual implementation are described in this specification. It will, of course, be appreciated that in the development of any such actual embodiment, numerous implementation-specific decisions must be made to achieve the developers' specific goals, such as compliance with system-related and business-related constraints, which will vary from one implementation to another. Moreover, it will be appreciated that such a development effort might be complex and time-consuming, but would nevertheless be a routine undertaking for those of ordinary skill in the art having the benefit of this disclosure.

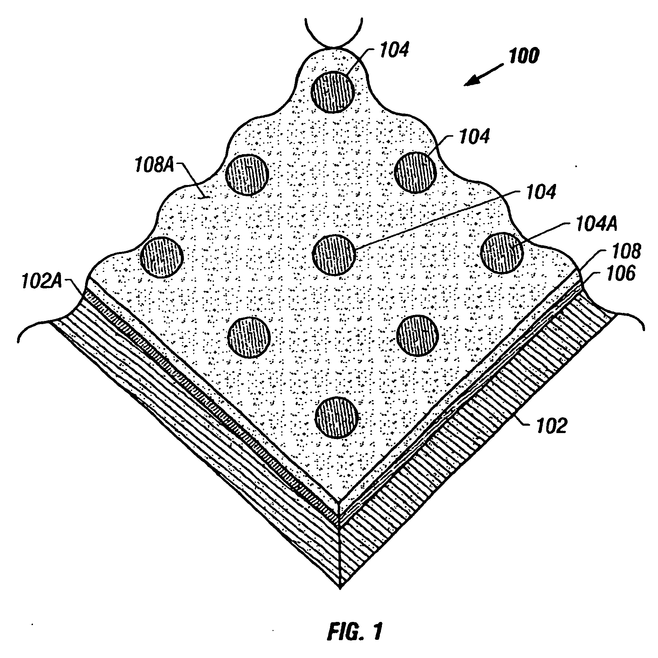

Figure 1 is a perspective view of a portion of one embodiment of a semiconductor device 100 including a semiconductor substrate 102, a compliant dielectric layer 106, an outer dielectric layer 108, and multiple electrically conductive, compliant bumps 104 extending through openings in the compliant dielectric layer 106 and the outer dielectric layer 108. As will be described below, each of the compliant bumps 104 is formed over a different one of multiple I/O pads (not shown in Figure 1) of the semiconductor device 100. The I/O pads are arranged upon an upper surface 102A of the substrate 102, and terminate electrical power and/or signal lines of the semiconductor device 100. The I/O pads are intended for connection to circuits external to the semiconductor device 100, and the compliant bumps 104 form electrical terminals of the semiconductor device 100.

As shown in Figure 1, the compliant dielectric layer 106 is positioned over the upper surface 102A of the substrate 102. The outer dielectric layer 108 is positioned over the compliant dielectric layer 106 such that the compliant dielectric layer 106 lies between the outer dielectric layer 108 and the upper surface 102A of the substrate 102. In combination, the compliant dielectric layer 106 and the outer dielectric layer 108 form a flexible passivation layer; a sealing layer to protect the upper surface 102A of the substrate 102 from moisture and contamination.

In the embodiment of Figure 1, the compliant bumps 104 extend through openings in the compliant dielectric layer 106, and through corresponding openings in the outer dielectric layer 108 such that upper surfaces 104A of the compliant bumps 104 protrude through an upper surface 108A of the outer dielectric layer 108. Where the upper surface 102A of the substrate 102 serves as an elevational reference surface, the upper surfaces 104A of the compliant bumps 104 are elevationally above the upper surface 108A.

During manufacture, the semiconductor substrate 102 may have been a part of a much larger semiconductor wafer. The compliant bumps 104 may have been formed on the semiconductor substrate 102 during manufacture, and before the semiconductor substrate 102 was separated from the larger semiconductor wafer.

The semiconductor substrate 102 may have multiple active and/or passive electrical devices formed thereon and/or therein. The multiple electrical devices may be interconnected to form one or more electrical circuits. In this situation, the semiconductor substrate 102 may be considered an integrated circuit die, and the semiconductor device 100 of Figure 1 may be considered a chip scale package (CSP).

It is noted that the I/O pads, the corresponding compliant bumps 104, the compliant dielectric layer 106, and the outer dielectric layer 108 may exist on and over more than one surface of the semiconductor substrate 102.

As will be described below, each of the compliant bumps 104 includes an electrically conductive, compliant body and an electrically conductive, solderable conductor element. The compliant body of each of the compliant bumps 104 is formed over an I/O pad of the semiconductor device 100, and the solderable conductor element is formed over the compliant body. The compliant body of each of the compliant bumps 104 is thus positioned between the I/O pad of the semiconductor device 100 and the corresponding solderable conductor element, and electrically couples the I/O pad to the corresponding solderable conductor element.

The solderable conductor elements of the compliant bumps 104 are intended to contact corresponding bonding pads of an element (e.g., a printed circuit board, a device package substrate, an integrated circuit die, etc.) to which the semiconductor device 100 is to be connected (i.e., attached or mounted). Hereinbelow, the element to which the semiconductor device 100 is to be connected will be referred to as "the connected element." In general, the solderable conductor elements are "solder wettable." That is, molten solder coming in contact with exposed surfaces of the solderable conductor elements will adhere to those surfaces, thus allowing solder to be used to electrically and mechanically couple the solderable conductor elements to the corresponding bonding pads of the connected element. A solder reflow operation may be used to couple the solderable conductor elements of the compliant bumps 104 to the corresponding bonding pads of the connected element via solder at substantially the same time.

Due primarily to the presence of the compliant bodies, the compliant bumps 104 are able to deform elastically when subjected to forces exerted between solderable conductor elements and the substrate 102. Such forces may be intentionally created between the semiconductor device 100 and an element to which the semiconductor device 100 is to be connected during the coupling of the solderable conductor elements to the corresponding bonding pads of the connected element in an effort to reduce or eliminate gaps existing between some of the solderable conductor elements and the corresponding bonding pads of the connected element. Such gaps typically result from differences in heights of the solderable conductor elements, non-planarities of surfaces of the substrate 102 and/or the connected element, etc.

Such forces are also expectedly created when the coefficient of thermal expansion (CTE) of the semiconductor device 100 does not match the CTE of the connected element. For example, during a solder reflow operation used to couple the solderable conductor elements to the corresponding bonding pads of the connected element, such forces are expectedly created due to the differences in the CTEs of the semiconductor device 100 and the connected element. Following the coupling of the solderable conductor elements to the corresponding bonding pads of the connected element, such forces are also expectedly created during thermal cycling due to the differences in the CTEs of the semiconductor device 100 and the connected element.

The abilities of the compliant bumps 104 to deform elastically under such forces allows the compliant bumps 104 to withstand such forces without the fatigue and failure typical of solder coating layer connections. The compliant bodies form mechanically flexible, electrically conductive paths between the solderable conductor elements and the corresponding I/O pads of the semiconductor device 100. As a result, the reliabilities of the connections formed between the semiconductor device 100 and the connected element using the compliant bumps 104 are expectedly greater than the reliabilities of solder coating layer connections.

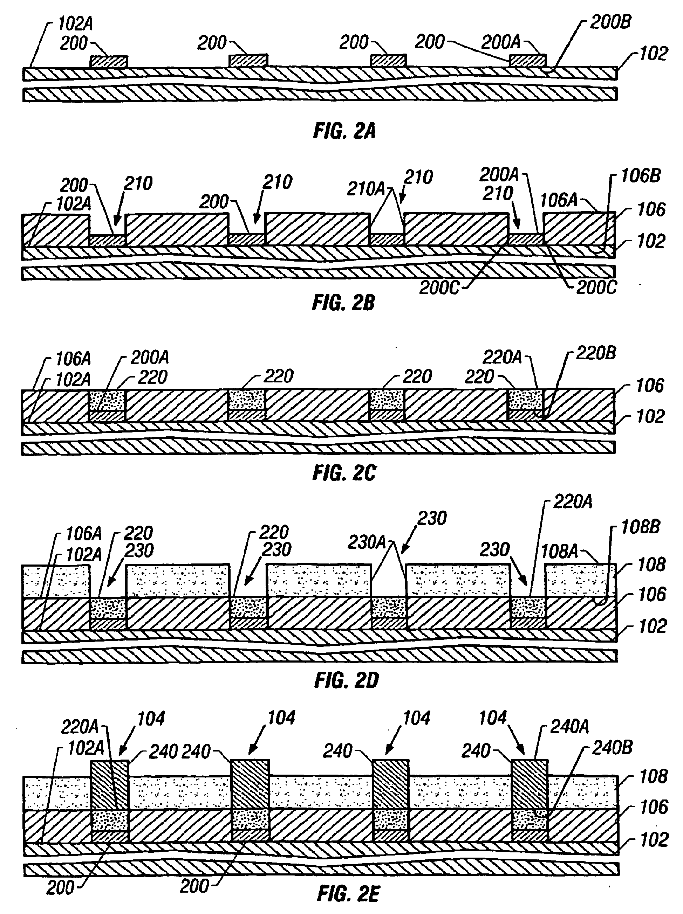

Figures 2A-2E will now be used to describe one embodiment of a method for fabricating the semiconductor device 100 of Figure 1. Figure 2A is a cross-sectional view of a portion of the substrate 102 of Figure 1, wherein multiple I/O pads 200 have been formed on the upper surface 102A of the substrate 102. For example, the I/O pads 200 may be formed by patterning a layer of a metal (e.g., aluminum or copper) formed on the upper surface 102A of the substrate 102. Each of the I/O pads 200 has two major surfaces: an underside surface 200B in contact with the upper surface 102A of the substrate 102, and an upper surface 200A opposite the underside surface 200B.

Figure 2B is the cross-sectional view of the portion of the substrate 102 of Figure 2A, wherein the compliant dielectric layer 106 (see Figure 1) has been formed over the upper surface 102A of the semiconductor substrate 102. The compliant dielectric layer 106 is substantially a sheet of compliant dielectric material having an upper surface 106A and an opposed underside surface 106B. In the embodiment of Figure 2B, the underside surface 106B of the compliant dielectric layer 106 is in direct, and substantially continuous, contact with the upper surface 102A of the semiconductor substrate 102.

The compliant dielectric material used to form the compliant dielectric layer 106 may be a polymer-based material. Such polymer-based materials include thermoplastics, thermosets, and B-stageable materials. Common types of suitable polymer materials include epoxy, silicone, polyimide, and acrylate polymers and copolymers. Such polymer materials may require curing after application for the material to acquire a desired shape and form at room temperature.

The compliant dielectric layer 106 may be formed by any one of several known methods, including screen printing, stencil printing, inkjet printing, sheet transfer of preformed films, and coating (e.g., spin coating). The compliant dielectric layer 106 may be a layer of a single compliant dielectric material, or multiple layers of different compliant dielectric materials.

In Figure 2B, multiple holes 210 have been formed in the compliant dielectric layer 106 over the I/O pads 200 to expose the upper surfaces 200A of the I/O pads 200. Each of the holes 210 extends between the upper surface 106A of the compliant dielectric layer 106 and the underside surface 106B (i.e., between the upper surface 106A of the compliant dielectric layer 106 and the upper surface 200A of a corresponding one of the I/O pads 200). The holes 210 may be formed in a solid sheet of compliant dielectric material using known photolithographic methods.

In the embodiment of Figure 2B, the side walls 210A of the holes 210 are contained within the outer boundaries of the corresponding I/O pads 200, as defined by the sides surfaces 200C of the corresponding I/O pads 200. Further, the side walls 210A of the holes 210 are substantially vertical such that dimensions of openings in the upper surface 106A and the underside surface 106B of the compliant dielectric layer 106, corresponding to the holes 210, have substantially the same dimensions. In other embodiments, the side walls 210A of the holes 210 may not be substantially vertical, and may not be contained within the outer boundaries of the corresponding I/O pads 200.

Regarding the electrical properties of the compliant dielectric layer 106, the volume resistivity of the compliant dielectric layer 106 should be greater than or equal to about 1.0 x 10¹⁰ ohm-cm. In one embodiment, the volume resistivity of the compliant dielectric layer 106 may be greater than or equal to approximately 1.0 x 10¹⁵ ohm-cm.

Regarding the mechanical properties of the compliant dielectric layer 106, the Young's modulus of a material is a ratio of unidirectional internal stress within the material to an initial strain placed upon it. When a magnitude of a force applied to the material is below a threshold level, the strain in the material resulting from the applied force is substantially proportional to the applied stress, and the material is said to exhibit substantially "Hookean" or ideal elasticity. In one embodiment, the Young's modulus of the compliant dielectric layer 106 may be less than or equal to about 8,000 MPa, and may be less than or equal to approximately 1,000 MPa.

Figure 2C is the cross-sectional view of the portion of the substrate 102 of Figure 2B, wherein electrically conductive, compliant bodies 220 have been formed in the holes 210. Each of the compliant bodies 220 has an upper surface 220A and an opposed underside surface 220B. In the embodiment of Figure 2C, the compliant bodies 220 substantially fill the corresponding holes 210, the underside surfaces 220B of the compliant bodies 220 are in direct contact with the upper surfaces 200A of the corresponding I/O pads 200, and the upper surfaces 220A of the compliant bodies 220 are substantially even with (i.e., flush with) the upper surface 106A of the compliant dielectric layer 106. It is noted that in other embodiments, the upper surfaces 220A of the compliant bodies 220 may be above or below the upper surface 106A of the compliant dielectric layer 106.

Formed within a corresponding one of the holes 210, each of the compliant bodies 220 is contained within the corresponding one of the holes 210. As described above, the side walls 210A of the holes 210 are contained within the outer boundaries of the corresponding I/O pads 200. (See Figure 2B.) Accordingly, each of the compliant bodies 220 is contained within an outer boundary of the corresponding one of the I/O pads 200 such that the compliant bodies 220 do not contact any portion of the upper surface 102A of the substrate 102 surrounding the conductive metal coating elements 300. In other embodiments, the side walls 210A of the holes 210 may not be contained within the outer boundaries of the corresponding I/O pads 200, and the compliant bodies 220 may contact a portion of the upper surface 102A of the substrate 102 surrounding the conductive metal coating elements 300.

The compliant bodies 220 may be formed from one or more polymer-based, electrically conductive materials. Such materials include thermoplastics, thermosets, and B-stageable materials. Common types of suitable polymer materials include epoxy, silicone, polyimide, and acrylate polymers and copolymers. Such polymer materials may require curing after application for the material to acquire a desired shape and form at room temperature.

Suitable electrical conductivity of the compliant bodies 220 may be achieved by incorporating one or more metallic fillers, such as silver, gold, palladium, and alloys thereof. Inherently conductive polymer compositions are also known, and may be used to form the compliant bodies 220. Commercially available filler material products include filler particles of various sizes and shapes. Such commercially available filler materials may be suitable.

The compliant bodies 220 may be formed using any one of several known methods, including screen printing, stencil printing, inkjet printing, sheet transfer of preformed bodies, coating (e.g., spin coating) followed by photoimaging, or photoimaging via multi-layer techniques. Regarding electrical conductivities of the compliant bodies 220, the achieved volume resistivity of the compliant bodies 220 should be less than or equal to about 0.001 ohm-cm. In one embodiment, the achieved volume resistivity of the compliant bodies 220 may be less than or equal to approximately 0.0001 ohm-cm. Regarding a lower limit for the volume resistivity, electrically conductive particle-filled compositions having volume resistivities as low as 0.00005 ohm-cm are attainable. Solid silver metal (99.78% pure) has a volume resistivity of 0.0000016 ohm-cm, which may be considered a practical lower limit of attainable volume resistivity.

Regarding the mechanical properties of the compliant bodies 220, the Young's modulus of the compliant bodies 220 may be less than or equal to about 8,000 MPa, and may be less than or equal to approximately 1,000 MPa. The compliant bodies 220 also have suitable measures of elongation and compressibility. Elongation is defined as the increase in a length of a specimen in tension, usually expressed as a percentage of the original length. Compressibility is defined as a decrease in a thickness of a specimen under compression, usually expressed as a percentage of the original thickness.

Figure 2D is the cross-sectional view of the portion of the substrate 102 of Figure 2C, wherein the outer dielectric layer 108 (see Figure 1) has been formed over the upper surface 106A of the compliant dielectric layer 106. The outer dielectric layer 108 is substantially a sheet of dielectric material having the upper surface 108A shown in Figure 1 and described above, and an opposed underside surface 108B. In the embodiment of Figure 2D, the underside surface 108B of the outer dielectric layer 108 is in direct, and substantially continuous, contact with the upper surface 106A of the compliant dielectric layer 106. The outer dielectric layer 108 may be a layer of a single dielectric material, or multiple layers of different dielectric materials.

The dielectric material used to form the outer dielectric layer 108 may be a polymer-based material. Such polymer-based materials include thermoplastics, thermosets, and B-stageable materials. Common types of suitable polymer materials include epoxy, silicone, polyimide, and acrylate polymers and copolymers. Such polymer materials may require curing after application for the material to acquire a desired shape and form at room temperature.

Where the outer dielectric layer 108 is a polymer-based material, the outer dielectric layer 108 may be formed by any one of several known methods, including screen printing, stencil printing, inkjet printing, sheet transfer of preformed films, and coating (e.g., spin coating).

The outer dielectric layer 108 may also be an inorganic dielectric material, such as silicon dioxide (SiO₂) or silicon nitride (Si₃N₄). Such inorganic dielectric materials may be deposited on the compliant dielectric layer 106 (e.g., via chemical vapor deposition or CVD).

Regarding the mechanical properties of the outer dielectric layer 108, the outer dielectric layer 108 is preferably mechanically "stiffer" than the compliant dielectric layer 106 such that when a force is applied to the upper surface 108A of the outer dielectric layer 108, the outer dielectric layer 108 deforms to a lesser extent than the compliant dielectric layer 106, and serves to distribute the applied force over a relatively wide area of the compliant dielectric layer 106. The Young's modulus of the outer dielectric layer 108 may be, for example, greater than or equal to approximately twice the Young's modulus of the compliant dielectric layer 106.

In Figure 2D, multiple holes 230 have been formed in the outer dielectric layer 108 over the compliant bodies 220 to expose the upper surfaces 220A of the compliant bodies 220. Each of the holes 230 extends between the upper surface 108A of the outer dielectric layer 108 and the underside surface 108B. The holes 230 may be formed in a solid sheet of dielectric material using known photolithographic methods.

In the embodiment of Figure 2D, the side walls 230A of the holes 230 are contained within the outer boundaries of the corresponding I/O pads 200, as defined by the sides surfaces 200C of the corresponding I/O pads 200. (See Figure 2B.) Further, the side walls 230A of the holes 230 are substantially vertical such that dimensions of openings in the upper surface 108A and the underside surface 108B of the outer dielectric layer 108, corresponding to the holes 230, have substantially the same dimensions. In other embodiments, the side walls 230A of the holes 230 may not be substantially vertical, and may not be contained within the outer boundaries of the corresponding I/O pads 200.

Figure 2E is the cross-sectional view of the portion of the substrate 102 of Figure 2D, wherein electrically conductive, solderable conductor elements 240 have been formed in the holes 230. Each of the solderable conductor elements 240 has an upper surface 240A and an opposed underside surface 240B. In the embodiment of Figure 2E, the solderable conductor elements 240 substantially fill the corresponding holes 230, the underside surfaces 240B of the solderable conductor elements 240 are in direct contact with the upper surfaces 220A of the corresponding compliant bodies 220, and the upper surfaces 240A of the solderable conductor elements 240 extend above the upper surface 108A of the outer dielectric layer 108. It is noted that in other embodiments, the upper surfaces 240A of the solderable conductor elements 240 may be even with, or below, the upper surface 108A of the outer dielectric layer 108.

Formed within a corresponding one of the holes 230, each of the solderable conductor elements 240 is contained within the corresponding one of the holes 230. In the embodiments of Figures 2D-2E, the side walls 230A of the holes 230 are contained within the outer boundaries of the corresponding I/O pads 200, defined by the side surfaces 200C of the corresponding I/O pads 200. (See Figure 2B.) Accordingly, each of the solderable conductor elements 240 is contained within an outer boundary of the corresponding one of the I/O pads 200.

As described above, the solderable conductor elements 240 are "solder wettable." That is, molten solder coming in contact with exposed surfaces of the solderable conductor elements 240 will adhere to those surfaces, thus allowing solder to be used to electrically and mechanically couple the solderable conductor elements 240 to corresponding bonding pads (not shown) of an element to which the semiconductor device 100 (Figure 1) is to be connected.

The solderable conductor elements 240 may be, for example, an alloy including two or more of the following metals: lead, tin, cadmium, indium, bismuth, and gallium. For example, the solderable conductor elements 240 may be formed from an alloy including about 95 percent by weight lead and approximately 5 percent by weight tin (e.g., 5/95 percent by weight tin/lead solder). Where the solderable conductor elements 240 is an alloy, suitable methods for forming the solderable conductor elements 240 include stencil printing, inkjet printing, and transfer processing. Alternately, the solderable conductor elements 240 may be formed from a material substantially comprising a single metal, such as copper, silver, platinum, palladium, nickel, or gold. Further, the solderable conductor elements 240 may be formed substantially of an alloy of the following metals: copper, silver, platinum, palladium, nickel, and gold. Where the solderable conductor elements 240 is a single metal or an alloy, the material used to form the solderable conductor elements 240 may be deposited via electroplating (using electrodes, or electroless).

A sufficient amount of material may be progressively built up in the holes 230 to achieve desired heights of the solderable conductive elements 240. For example, if the solderable conductor elements 240 are formed via electroplating, the electroplating operation may be conducted for sufficient time that enough material is built up in the holes 230 to achieve the desired heights of the solderable conductive elements 240.

For example, in an electroplating process used to form the solderable conductive elements 240, the compliant bodies 220 may act as electrode terminals. As an applied electrical current flows through the compliant bodies 220 and an electrolyte solution containing metal ions, the metal ions from the electrolyte solution are deposited on the upper surfaces 220A of the compliant bodies 220. As the outer dielectric layer 108 is nonconductive, metal ions are not deposited on surfaces of the dielectric layer 108 exposed to the electrolyte solution. The achieved heights of the solderable conductive elements 240 are dependent upon the amount of time the electroplating process is carried out. The upper surfaces 240A of the resulting solderable conductive elements 240 may be made to extend above the upper surface 108A of the outer dielectric layer 108 by continuing the electroplating process after the heights of the solderable conductive elements 240 have exceeded a thickness of the outer dielectric 108.

Alternately, the solderable conductive elements 240 may be formed using a sputter deposition process. A masking layer having openings (i.e., holes) extending therethrough may be formed on the upper surface 108A of the outer dielectric layer 108. Each of the holes corresponds to a different one of the holes 230 in the outer dielectric layer 108, and exposes the upper surface 220A of a different one of the compliant bodies 220. Metal is then sputtered from a side of the masking layer opposite the outer dielectric layer 108. The sputtered metal travels through the holes in the masking layer, through the corresponding holes 230 in the outer dielectric layer 108, and is deposited on the upper surfaces 220A of the compliant bodies 220. The masking layer prevents the sputtered metal form being deposited on the upper surface 108A of the outer dielectric layer 108. The achieved heights of the solderable conductive elements 240 are dependent upon the amount of time the sputtering process is carried out. The upper surfaces 240A of the resulting solderable conductive elements 240 may be made to extend above the upper surface 108A of the outer dielectric layer 108 by continuing the sputtering process after the heights of the solderable conductive elements 240 have exceeded a thickness of the outer dielectric 108. Following the completion of the sputtering process, the masking layer may be removed.

An ink jet printing process used to form the solderable conductive elements 240 may involve a paste containing metallic and non-metallic components (e.g., a solder paste). The paste may be forced through multiple needles, each corresponding to, and directed into, a different one of the holes 230 in the outer dielectric layer 108. Small quantities (i.e., "dots") of the paste forced through each of the needles may be deposited on the upper surface 220A of a compliant body 220. After one or more dots of the paste are deposited on the upper surfaces 220A of the compliant bodies 220, the semiconductor device 100 may be heated to drive off the non-metallic components of the dots of the paste, and to reflow the dots of the paste to form a continuous metallic layer. The above described sequence of depositing one or more dots of the paste and heating the semiconductor device 100 may be continued until the desired heights of the solderable conductor elements 240 are achieved. Should the desired heights of the solderable conductor elements 240 exceed a thickness of the outer dielectric layer 108, the surface tension of the molten metallic components substantially keeps the portions of the solderable conductor elements 240 extending above the upper surface 108A of the outer dielectric layer 108 within a boundary defined by the side walls 230A of the holes 230 in the outer dielectric layer 108.

In a stencil printing operation used to form the solderable conductive elements 240, the solderable conductive elements 240 may be stencil printed simultaneously. The desired heights of the solderable conductive elements 240 may be achieved in a single stencil printing operation. Alternately, multiple stencil printing operations may be carried out sequentially, wherein the solderable conductive elements 240 are formed by layering. Where layering is used, the desired heights of the solderable conductive elements 240 are the sums of the heights of the separate stencil printed layers.

The structures shown in Figure 2E are one embodiment of the compliant bumps 104 of Figure 1. When a body applies a force between the upper surface 240A of one or more of the solderable conductor elements 240 and the substrate 102, the applied force is substantially transmitted to the corresponding compliant bodies 220. In response to the applied force, the compliant bodies 220 deform, providing stress relief to the corresponding I/O pads 200. When the magnitude of the applied force is below a certain level (e.g., a threshold level), the compliant bodies 220 deform in a substantially elastic manner under the applied force. A force is generated within the compliant bodies 220 that opposes the applied force, and maintains physical contact between the one or more solderable conductor elements 240 and the body applying the applied force to the upper surface 240A of the one or more solderable conductor elements 240. When the applied force is removed, the compliant bodies 220 substantially recover to their original sizes and shapes. The compliant bodies 220 thus have a suitable measure of elasticity.

The compliant dielectric layer 106 also has a suitable measure of elasticity, and provides stress relief for the outer dielectric layer 108, and for the upper surface 102A of the substrate 102. When a force is applied to the upper surface 108A of the outer dielectric layer 108, the applied force is substantially transmitted to the compliant dielectric layer 106. In response to the applied force, the compliant dielectric layer 106 deforms, allowing the outer dielectric layer 108 to move in relation to the upper surface 102A of the substrate 102, and reducing the amount of stress generated within the outer dielectric layer 108. When the magnitude of the applied force is below a certain level (e.g., a threshold level), the compliant dielectric layer 106 deforms under the applied force, and the outer dielectric layer 108 bends under the applied force without breaking. When the applied force is removed, the outer dielectric layer 108 returns to its original position, and the compliant dielectric layer 106 substantially recovers to its original size and shape.

The outer dielectric layer 108 provides mechanical protection for the upper surface 102A of the substrate 102, and for the compliant dielectric layer 106. The outer dielectric layer 108 acts as a barrier to migration of contaminants from an ambient surrounding the semiconductor device 100 to the compliant dielectric layer 106, and to the upper surface 102A of the substrate 102. Further, the outer dielectric layer 108 may be resistant to solvents, and may provide protection for the compliant dielectric layer 106, and the upper surface 102A of the substrate 102, during operations where the semiconductor device 100 is exposed to solvents. Still further, the outer dielectric layer 108 may act as a barrier to migration of contaminants from the compliant dielectric layer 106 to the ambient. At edges of the semiconductor device 100, the outer dielectric layer 108 preferably covers the compliant dielectric layer 106 layer completely.

When the force is applied to the upper surface 108A of the outer dielectric layer 108, the outer dielectric layer 108 deforms less than the compliant dielectric layer 106, and serves to distribute the applied force over a greater area of the compliant dielectric layer 106. Components of forces applied to the compliant bumps 104 and transferred to the outer dielectric layer 108 are similarly distributed by the outer dielectric layer 108 over a relatively wide area, improving the reliabilities of the compliant bumps 104. The outer dielectric layer 108 provides puncture, cut, tear, and abrasion resistance for the compliant dielectric layer 106.

In the embodiment of Figures 2B-2E, the side walls 210A of the holes 210, and the side walls 230A of the holes 230, are contained within the outer boundaries of the corresponding I/O pads 200, as defined by the sides surfaces 200C of the I/O pads 200. (see Figure 2B.) In other embodiments, the side walls 210A and 230A may not be contained within the outer boundaries of the corresponding I/O pads 200. In such embodiments, the underside surfaces 220B of the compliant bodies 220 may be in direct contact with the upper surfaces 200A of the corresponding I/O pads 200, the sides surfaces 200C of the corresponding I/O pads 200, and portions of the upper surface 102A of the substrate 200 surrounding the corresponding I/O pads 200. This arrangement may be beneficial in that the cross sectional areas of the compliant bodies 220 and the solderable conductor elements 240 are increased, and the electrical conductivities of the complaint bodies 220 and the solderable conductor elements 240 may be increased as a result. The increased cross sectional areas of the compliant bodies 220 may also increase dimensions of regions within the complaint bodies 220 in which thermo-mechanically induced stresses are elastically dissipated.

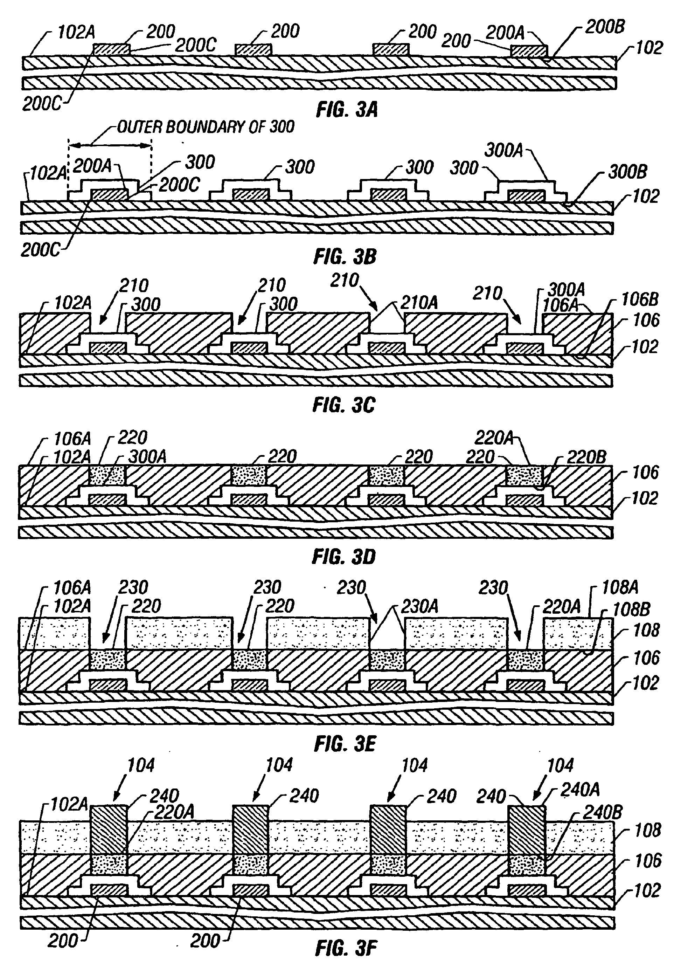

Figures 3A-3F will now be used to describe a second embodiment of the method for fabricating the semiconductor device 100 of Figure 1. Figure 3A is a cross-sectional view of a portion of the substrate 102 of Figure 1, wherein the multiple I/O pads 200 described above have been formed on the upper surface 102A of the substrate 102.

Figure 3B is the cross-sectional view of the portion of the substrate 102 of Figure 3A, wherein electrically conductive metal coating elements 300 have been formed over the upper surface 200A and the side surfaces 200C of the I/O pads 200, and over a portion of the upper surface 102A of the substrate 102 surrounding each of the I/O pads 200. Each of the conductive metal coating elements 300 has an upper surface 300A, and an opposed underside surface 300B. In the embodiment of Figure 3B, the underside surface 300B of each of the conductive metal coating elements 300 is in direct contact with the upper surface 200A and the side surfaces 200C of a corresponding one of the I/O pads 200, and also with a portion of the upper surface 102A of the substrate 102 surrounding the corresponding one of the I/O pads 200. Accordingly, an outer boundary of each of the conductive metal coating elements 300 extends beyond an outer boundary of the corresponding I/O pad 200, defined by the sides surfaces 200C of the corresponding I/O pad 200.

The conductive metal coating elements 300 may serve as adhesion layers, wherein a material subsequently formed on the conductive metal coating elements 300 adheres better to the conductive metal coating elements 300 than to the I/O pads 200. Alternately, or in addition, the conductive metal coating elements 300 may serve as barrier layers to reduce oxidation of the I/O pads 200. Further, the conductive metal coating elements 300 may also serve as electrodes for a subsequent electroplating operation.

The conductive metal coating elements 300 may be formed by, for example, forming layers of one or more electrically conductive metals over the I/O pads 200 and the upper surface 102A of the substrate 102 surrounding the I/O pads 200 (e.g., via electroplating or evaporation), and patterning the one or more layers (e.g., via photolithography). For example, the conductive metal coating elements 300 may be formed by forming layers of chromium, copper, and gold over the I/O pads 200 in that order (i.e., chrome/copper/gold layers). Alternately, the conductive metal coating elements 300 may include chrome/silver/gold layers, or titanium/tungsten/gold layers. For example, the I/O pads 200 may be formed from aluminum, and the conductive metal coating elements 300 may be formed, for example, by forming a layer of chromium about 0.15 micron in thickness (i.e., an approximate 0.15 um chromium layer) over the I/O pads 200, followed by a 50/50 chromium copper layer approximately 0.15 um in thickness, followed by an approximate 1 um copper layer, followed by an approximate 0.15 um gold layer.

Figure 3C is the cross-sectional view of the portion of the substrate 102 of Figure 3B, wherein the compliant dielectric layer 106 described above has been formed over the conductive metal coating elements 300 and the portion of the upper surface 102A of the semiconductor substrate 102 surrounding the conductive metal coating elements 300. In the embodiment of Figure 3C, the underside surface 106B of the compliant dielectric layer 106 is in direct contact with the upper surfaces 300A of the conductive metal coating elements 300, and the portion of the upper surface 102A of the semiconductor substrate 102 surrounding the conductive metal coating elements 300.

In Figure 3C, the holes 210 described above have been formed in the compliant dielectric layer 106. In Figure 3C, the holes 210 are formed over the conductive metal coating elements 300 to expose portions of the upper surfaces 300A of the conductive metal coating elements 300. Each of the holes 210 extends between the upper surface 106A of the compliant dielectric layer 106 and the underside surface 106B (i.e., between the upper surface 106A of the compliant dielectric layer 106 and the upper surface 300A of a corresponding conductive metal coating element 300).

In the embodiment of Figure 3C, the side walls 210A of the holes 210 are contained within the outer boundaries of the corresponding conductive metal coating elements 300. (See Figure 3B.) Further, the side walls 210A of the holes 210 are substantially vertical such that dimensions of openings in the upper surface. 106A and the underside surface 106B of the compliant dielectric layer 106, corresponding to the holes 210, have substantially the same dimensions. In other embodiments, the side walls 210A of the holes 210 may not be substantially vertical, and may not be contained within the outer boundaries of the corresponding conductive metal coating elements 300.

Figure 3D is the cross-sectional view of the portion of the substrate 102 of Figure 3C, wherein the electrically conductive, compliant bodies 220 described above have been formed in the holes 210. In the embodiment of Figure 3D, the compliant bodies 220 substantially fill the corresponding holes 210, the underside surfaces 220B of the compliant bodies 220 are in direct contact with the upper surfaces 300A of the corresponding conductive metal coating elements 300, and the upper surfaces 220A of the compliant bodies 220 are substantially flush with the upper surface 106A of the compliant dielectric layer 106.

Formed within a corresponding one of the holes 210, each of the compliant bodies 220 is contained within the corresponding one of the holes 210. (See Figures 3C and 3D.) As described above, the side walls 210A of the holes 210 are contained within the outer boundaries of the corresponding conductive metal coating elements 300. (See Figure 3B.) Accordingly, each of the compliant bodies 220 is contained within an outer boundary of the corresponding conductive metal coating element 300 such that the compliant bodies 220 do not contact any portion of the upper surface 102A of the substrate 102 surrounding the conductive metal coating elements 300. In other embodiments, the side walls 210A of the holes 210 may not be contained within the outer boundaries of the corresponding conductive metal coating elements 300, and the compliant bodies 220 may contact a portion of the upper surface 102A of the substrate 102 surrounding the conductive metal coating elements 300.

Figure 3E is the cross-sectional view of the portion of the substrate 102 of Figure 3D, wherein the outer dielectric layer 108 described above has been formed over the upper surface 106A of the compliant dielectric layer 106. In the embodiment of Figure 3E, the underside surface 108B of the outer dielectric layer 108 is in direct, and substantially continuous, contact with the upper surface 106A of the compliant dielectric layer 106.

In Figure 3E, the holes 230 described above have been formed in the outer dielectric layer 108 over the compliant bodies 220 to expose the upper surfaces 220A of the compliant bodies 220. Each of the holes 230 extends between the upper surface 108A of the outer dielectric layer 108 and the underside surface 108B. In the embodiment of Figure 3E, the side walls 230A of the holes 230 are contained within the outer boundaries of the corresponding conductive metal coating elements 300. (See Figure 3B.) Further, the side walls 230A of the holes 230 are substantially vertical such that dimensions of openings in the upper surface 108A and the underside surface 108B of the outer dielectric layer 108, corresponding to the holes 230, have substantially the same dimensions. In other embodiments, the side walls 230A of the holes 230 may not be substantially vertical, and may not be contained within the outer boundaries of the corresponding conductive metal coating elements 300.

Figure 3F is the cross-sectional view of the portion of the substrate 102 of Figure 3E, wherein the electrically conductive, solderable conductor elements 240 described above have been formed in the holes 230. In the embodiment of Figure 3F, the solderable conductor elements 240 substantially fill the corresponding holes 230, the underside surfaces 240B of the solderable conductor elements 240 are in direct contact with the upper surfaces 220A of the corresponding compliant bodies 220, and the upper surfaces 240A of the solderable conductor elements 240 extend above the upper surface 108A of the outer dielectric layer 108. It is noted that in other embodiments, the upper surfaces 240A of the solderable conductor elements 240 may be even with, or below, the upper surface 108A of the outer dielectric layer 108.

Formed within a corresponding one of the holes 230, each of the solderable conductor elements 240 is contained within the corresponding one of the holes 230. In the embodiments of Figures 3E-3F, the side walls 230A of the holes 230 are contained within the outer boundaries of the corresponding conductive metal coating elements 300. (See Figure 3B.) Accordingly, each of the solderable conductor elements 240 is contained within an outer boundary of the corresponding one of the conductive metal coating elements 300.

The structures shown in Figure 3F are a second embodiment of the compliant bumps 104 of Figure I. As described above, when a body applies a force between the upper surface 240A of one or more of the solderable conductor elements 240 and the substrate 102, the applied force is substantially transmitted to the corresponding compliant bodies 220 (see Figures 3C and 3D). In response to the applied force, the compliant bodies 220 deform, providing stress relief to the corresponding I/O pads 200. When the magnitude of the applied force is below a certain level (e.g., a threshold level), the compliant bodies 220 deform in a substantially elastic manner under the applied force. A force is generated within the compliant bodies 220 that opposes the applied force, and maintains physical contact between the one or more solderable conductor elements 240 and the body applying the applied force to the upper surface 240A of the one or more solderable conductor elements 240. When the applied force is removed, the compliant bodies 220 substantially recover to their original sizes and shapes.

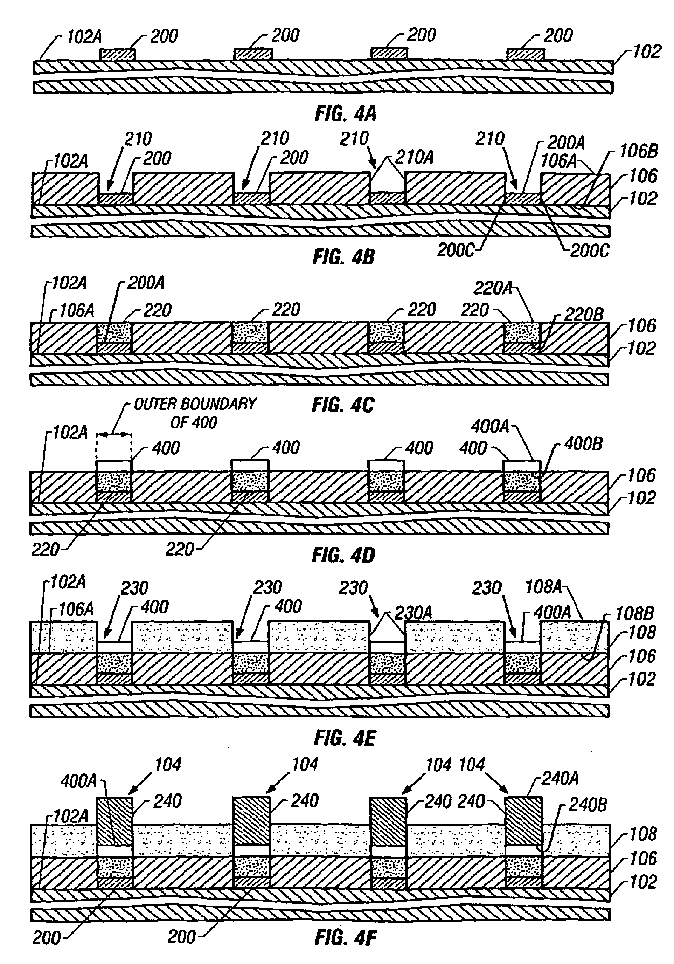

Figures 4A-4F will now be used to describe a third embodiment of the method for fabricating the semiconductor device 100 of Figure 1. Figure 4A is a cross-sectional view of a portion of the substrate 102 of Figure 1, wherein the multiple I/O pads 200 described above have been formed on the upper surface 102A of the substrate 102.

Figure 4B is the cross-sectional view of the portion of the substrate 102 of Figure 4A, wherein the compliant dielectric layer 106 described above has been formed over the upper surface 102A of the semiconductor substrate 102. In the embodiment of Figure 4B, the underside surface 106B of the compliant dielectric layer 106 is in direct, and substantially continuous, contact with the upper surface 102A of the semiconductor substrate 102. The holes 210 described above have been formed in the compliant dielectric layer 106 over the I/O pads 200 to expose the upper surfaces 200A of the I/O pads 200.

In the embodiment of Figure 4B, the side walls 210A of the holes 210 are contained within the outer boundaries of the corresponding I/O pads 200, as defined by the sides surfaces 200C of the corresponding I/O pads 200. Further, the side walls 210A of the holes 210 are substantially vertical such that dimensions of openings in the upper surface 106A and the underside surface 106B of the compliant dielectric layer 106, corresponding to the holes 210, have substantially the same dimensions. In other embodiments, the side walls 210A of the holes 210 may not be substantially vertical, and may not be contained within the outer boundaries of the corresponding I/O pads 200.

Figure 4C is the cross-sectional view of the portion of the substrate 102 of Figure 4B, wherein the compliant bodies 220 described above have been formed in the holes 210. In the embodiment of Figure 2C, the compliant bodies 220 substantially fill the corresponding holes 210, the underside surfaces 220B of the compliant bodies 220 are in direct contact with the upper surfaces 200A of the corresponding I/O pads 200, and the upper surfaces 220A of the compliant bodies 220 are substantially flush with the upper surface 106A of the compliant dielectric layer 106.

Formed within a corresponding one of the holes 210, each of the compliant bodies 220 is contained within the corresponding one of the holes 210. In the embodiment of Figure 4C, the side walls 210A of the holes 210 are contained within the outer boundaries of the corresponding I/O pads 200, as defined by the side surfaces 200C of the corresponding I/O pads 200. (See Figure 4B.) Accordingly, each of the compliant bodies 220 is contained within an outer boundary of the corresponding one of the I/O pads 200 such that the compliant bodies 220 do not contact any portion of the upper surface 102A of the substrate 102 surrounding the conductive metal coating elements 300. In other embodiments, the side walls 210A of the holes 210 may not be contained within the outer boundaries of the corresponding I/O pads 200, and the compliant bodies 220 may contact a portion of the upper surface 102A of the substrate 102 surrounding the conductive metal coating elements 300.

Figure 4D is the cross-sectional view of the portion of the substrate 102 of Figure 4C, wherein electrically conductive metal coating elements 400 have been formed over the upper surfaces 220A of the compliant bodies 220. Each of the conductive metal coating elements 400 has an upper surface 400A, and an opposed underside surface 400B. In the embodiment of Figure 4D, the underside surface 400B of each of the conductive metal coating elements 400 is in direct contact with the upper surface 220A of a corresponding one of the compliant bodies 220. Further, an outer boundary of each of the conductive metal coating elements 400 does not extend beyond an outer boundary of the corresponding I/O pad 200, defined by the sides surfaces 200C of the corresponding I/O pad 200.

The conductive metal coating elements 400 may serve as adhesion layers, wherein a material subsequently formed on the conductive metal coating elements 400 adheres better to the conductive metal coating elements 400 than to the corresponding compliant bodies 220. Alternately, or in addition, the conductive metal coating elements 400 may serve as barrier layers to prevent chemical reactions between the subsequently formed layer and the compliant bodies 220. Further, the conductive metal coating elements 400 may also serve as electrodes for a subsequent electroplating operation. The conductive metal coating elements 400 may be formed from the same materials as the conductive metal coating elements 300 described above, and may be formed using the same methods used to form the conductive metal coating elements 300.

Sufficient amounts of materials used to form the conductive metal coating elements 400 may be deposited on the upper surfaces 220A of the complaint bodies 220 to achieve desired thicknesses of the conductive metal coating elements 400. For example, if the conductive metal coating elements 400 are formed via electroplating (using electrodes, or electroless), the electroplating operation may be conducted for sufficient time that enough material is built up on the upper surfaces 220A of the complaint bodies 220 to achieve the desired thicknesses of the conductive metal coating elements 400.

For example, in electroplating processes used to form the conductive metal coating elements 400, the compliant bodies 220 may act as electrode terminals. As an applied electrical current flows through the compliant bodies 220 and an electrolyte solution containing metal ions, metal ions from the electrolyte solution are deposited on the upper surfaces 220A of the compliant bodies 220. As the compliant dielectric layer 106 is nonconductive, metal ions will not be deposited on surfaces of the compliant dielectric layer 106 exposed to the electrolyte solution. The achieved thicknesses of the conductive metal coating elements 400 are dependent upon the amounts of time the electroplating processes are carried out.

Alternately, the conductive metal coating elements 400 may be formed using sputter deposition processes. A masking layer having openings (i.e., holes) extending therethrough may be formed on the upper surface 106A of the complaint dielectric layer 106. Each of the holes exposes the upper surface 220A of a different one of the compliant bodies 220. Metal is then sputtered from a side of the masking layer opposite the complaint dielectric layer 106. Sputtered metal travels through the holes in the masking layer is deposited on the upper surfaces 220A of the compliant bodies 220. The masking layer prevents the sputtered metal from depositing on the upper surface 106A of the complaint dielectric layer 106. The achieved thicknesses of the conductive metal coating elements 400 are dependent upon the amounts of time the sputtering processes are carried out. Following the completion of the sputtering process, the masking layer may be removed.

In a stencil printing operation used to form the conductive metal coating elements 400, the conductive metal coating elements 400 may be stencil printed simultaneously. The desired heights of the conductive metal coating elements 400 may be achieved in a single stencil printing operation. Alternately, multiple stencil printing operations may be carried out sequentially, wherein the conductive metal coating elements 400 are formed by layering. Where layering is used, the desired thicknesses of the conductive metal coating elements 400 are the sums of the heights of the separate stencil printed layers.

Figure 4E is the cross-sectional view of the portion of the substrate 102 of Figure 4D, wherein the outer dielectric layer 108 described above has been formed over the upper surface 106A of the compliant dielectric layer 106. In the embodiment of Figure 4E, the underside surface 108B of the outer dielectric layer 108 is in direct, and substantially continuous, contact with the upper surface 106A of the compliant dielectric layer 106.

In Figure 4E, the holes 230 described above have been formed in the outer dielectric layer 108 over the conductive metal coating elements 400 to expose the upper surfaces 400A of the conductive metal coating elements 400. In the embodiment of Figure 4E, the side walls 230A of the holes 230 are contained within the outer boundaries of the corresponding conductive metal coating elements 400. (See Figure 4D.) Further, the side walls 230A of the holes 230 are substantially vertical such that dimensions of openings in the upper surface 108A and the underside surface 108B of the outer dielectric layer 108, corresponding to the holes 230, have substantially the same dimensions. It is noted that in other embodiments, the side walls 230A of the holes 230 may not be substantially vertical.

Figure 4F is the cross-sectional view of the portion of the substrate 102 of Figure 4E, wherein the electrically conductive, solderable conductor elements 240 described above have been formed in the holes 230. In the embodiment of Figure 4F, the solderable conductor elements 240 substantially fill the corresponding holes 230, the underside surfaces 240B of the solderable conductor elements 240 are in direct contact with the upper surfaces 400A of the corresponding conductive metal coating elements 400, and the upper surfaces 240A of the solderable conductor elements 240 extend above the upper surface 108A of the outer dielectric layer 108. It is noted that in other embodiments, the upper surfaces 240A of the solderable conductor elements 240 may be even with, or below, the upper surface 108A of the outer dielectric layer 108.

Formed within a corresponding one of the holes 230, each of the solderable conductor elements 240 is contained within the corresponding one of the holes 230. In the embodiments of Figures 4E-4F, the side walls 230A of the holes 230 are contained within the outer boundaries of the corresponding conductive metal coating elements 400. (See Figure 4D.) Accordingly, each of the solderable conductor elements 240 is contained within an outer boundary of the corresponding one of the conductive metal coating elements 400.

The structures shown in Figure 4F are a third embodiment of the compliant bumps 104 of Figure 1. As described above, when a body applies a force between the upper surface 240A of one or more of the solderable conductor elements 240 and the substrate 102, the applied force is substantially transmitted to the corresponding compliant bodies 220 (see Figure 4C). In response to the applied force, the compliant bodies 220 deform, providing stress relief to the corresponding I/O pads 200. When the magnitude of the applied force is below a certain level (e.g., a threshold level), the compliant bodies 220 deform in a substantially elastic manner under the applied force. A force is generated within the compliant bodies 220 that opposes the applied force, and maintains physical contact between the one or more solderable conductor elements 240 and the body applying the applied force to the upper surface 240A of the one or more solderable conductor elements 240. When the applied force is removed, the compliant bodies 220 substantially recover to their original sizes and shapes.

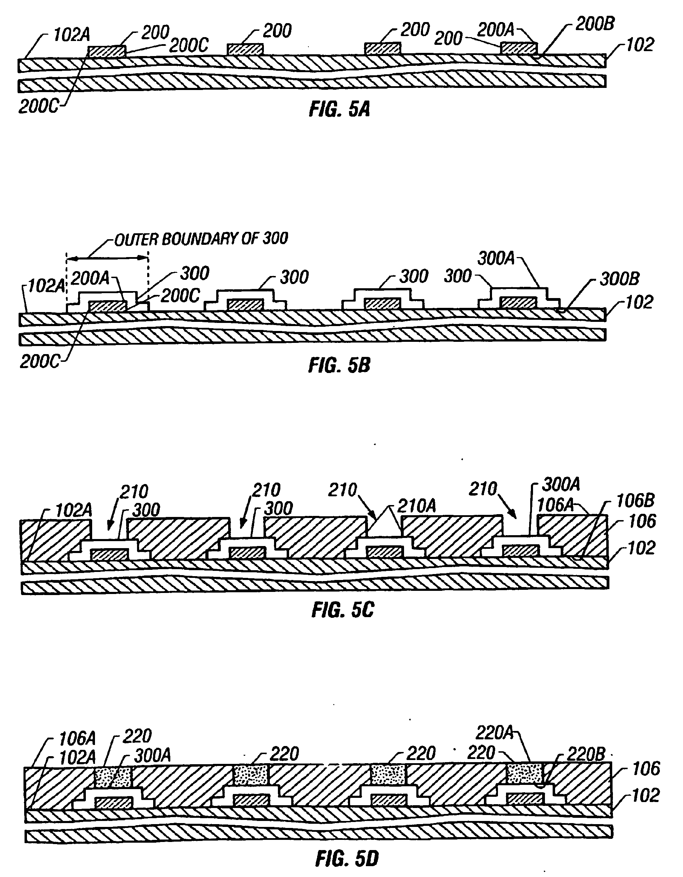

Figures 5A-5G will now be used to describe a fourth embodiment of the method for fabricating the semiconductor device 100 of Figure 1. Figure 5A is a cross-sectional view of a portion of the substrate 102 of Figure 1, wherein the multiple I/O pads 200 described above have been formed on the upper surface 102A of the substrate 102.

Figure 5B is the cross-sectional view of the portion of the substrate 102 of Figure 5A, wherein the electrically conductive metal coating elements 300 described above have been formed over the upper surface 200A and the side surfaces 200C of the I/O pads 200, and over a portion of the upper surface 102A of the substrate 102 surrounding each of the I/O pads 200. In the embodiment of Figure 5B, the underside surface 300B of each of the conductive metal coating elements 300 is in direct contact with the upper surface 200A and the side surfaces 200C of a corresponding one of the I/O pads 200, and also with a portion of the upper surface 102A of the substrate 102 surrounding the corresponding one of the I/O pads 200.

In the embodiment of Figure 5B, the outer boundary of each of the conductive metal coating elements 300 extends beyond the outer boundary of the corresponding I/O pad 200, defined by the sides surfaces 200C of the corresponding I/O pad 200. The conductive metal coating elements 300 may serve adhesion layers, wherein a material subsequently formed on the conductive metal coating elements 300 adheres better to the conductive metal coating elements 300 than to the I/O pads 200. Alternately, or in addition, the conductive metal coating elements 300 may serve as barrier layers to reduce oxidation of the I/O pads 200.

Figure 5C is the cross-sectional view of the portion of the substrate 102 of Figure 5B, wherein the compliant dielectric layer 106 described above has been formed over the conductive metal coating elements 300 and the portion of the upper surface 102A of the semiconductor substrate 102 surrounding the conductive metal coating elements 300. In the embodiment of Figure 5C, the underside surface 106B of the compliant dielectric layer 106 is in direct contact with the upper surfaces 300A of the conductive metal coating elements 300, and the portion of the upper surface 102A of the semiconductor substrate 102 surrounding the conductive metal coating elements 300.

In Figure 5C, the holes 210 described above have been formed in the compliant dielectric layer 106. In Figure 5C, the holes 210 are formed over the conductive metal coating elements 300 to expose portions of the upper surfaces 300A of the conductive metal coating elements 300. Each of the holes 210 extends between the upper surface 106A of the compliant dielectric layer 106 and the underside surface 106B (i.e., between the upper surface 106A of the compliant dielectric layer 106 and the upper surface 300A of a corresponding conductive metal coating element 300).

In the embodiment of Figure 5C, the side walls 210A of the holes 210 are contained within the outer boundaries of the corresponding conductive metal coating elements 300. (See Figure 5B.) Further, the side walls 210A of the holes 210 are substantially vertical such that dimensions of openings in the upper surface 106A and the underside surface 106B of the compliant dielectric layer 106, corresponding to the holes 210, have substantially the same dimensions. It is noted that in other embodiments, the side walls 210A of the holes 210 may not be substantially vertical.

Figure 5D is the cross-sectional view of the portion of the substrate 102 of Figure 5C, wherein the electrically conductive, compliant bodies 220 described above have been formed in the holes 210. In the embodiment of Figure 5D, the compliant bodies 220 substantially fill the corresponding holes 210, the underside surfaces 220B of the compliant bodies 220 are in direct contact with the upper surfaces 300A of the corresponding conductive metal coating elements 300, and the upper surfaces 220A of the compliant bodies 220 are substantially flush with the upper surface 106A of the compliant dielectric layer 106.

Formed within a corresponding one of the holes 210, each of the compliant bodies 220 is contained within the corresponding one of the holes 210 (see Figure 5C). As described above, in the embodiment of Figure 5C, the side walls 210A of the holes 210 are contained within the outer boundaries of the corresponding conductive metal coating elements 300 (see Figure 5B). Accordingly, in the embodiment of Figure 5D, each of the compliant bodies 220 is contained within an outer boundary of the corresponding conductive metal coating element 300 such that the compliant bodies 220 do not contact any portion of the upper surface 102A of the substrate 102 surrounding the conductive metal coating elements 300. In other embodiments, the side walls 210A of the holes 210 may not be contained within the outer boundaries of the corresponding conductive metal coating elements 300, and the compliant bodies 220 may contact a portion of the upper surface 102A of the substrate 102 surrounding the conductive metal coating elements 300.

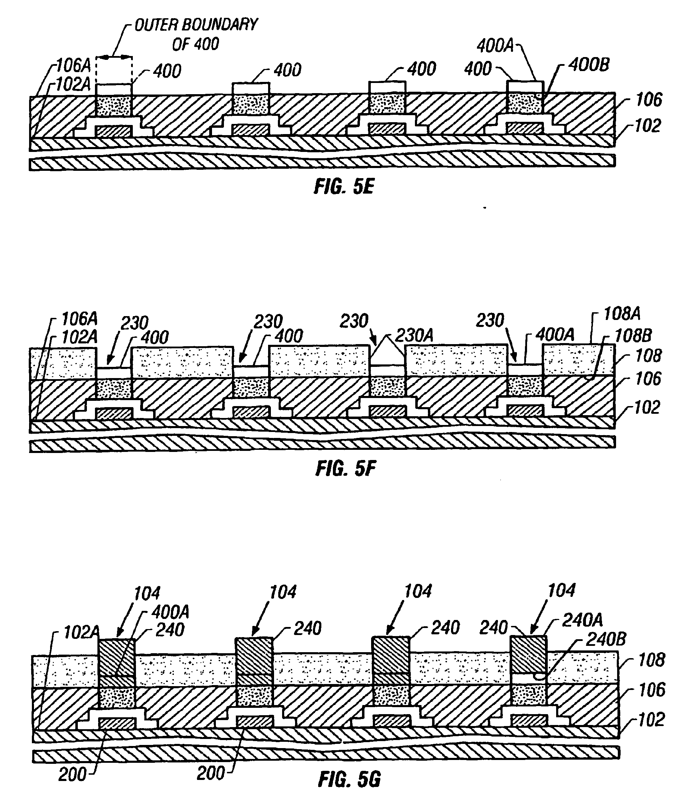

Figure 5E is the cross-sectional view of the portion of the substrate 102 of Figure 5D, wherein the electrically conductive metal coating elements 400 described above have been formed over the upper surfaces 220A of the compliant bodies 220. In the embodiment of Figure 5E, the underside surface of each of the conductive metal coating elements 400 is in direct contact with the upper surface 220A of a corresponding one of the compliant bodies 220, and an outer boundary of each of the conductive metal coating elements 400 does not extend beyond an outer boundary of the corresponding I/O pad 200, defined by the sides surfaces 200C of the corresponding I/O pad 200. (See Figure 5A).

The conductive metal coating elements 400 may serve as adhesion layers, wherein a material subsequently formed on the conductive metal coating elements 400 adheres better to the conductive metal coating elements 400 than to the corresponding compliant bodies 220. Alternately, or in addition, the conductive metal coating elements 400 may serve as barrier layers to prevent chemical reactions between the subsequently formed layer and the compliant bodies 220. The conductive metal coating elements 400 may be formed from the same materials as the conductive metal coating elements 300 described above, and may be formed using the same methods used to form the conductive metal coating elements 300.

Figure 5F is the cross-sectional view of the portion of the substrate 102 of Figure 5E, wherein the outer dielectric layer 108 described above has been formed over the upper surface 106A of the compliant dielectric layer 106. In the embodiment of Figure 5F, the underside surface 108B of the outer dielectric layer 108 is in direct, and substantially continuous, contact with the upper surface 106A of the compliant dielectric layer 106.

In Figure 5F, the holes 230 described above have been formed in the outer dielectric layer 108 over the conductive metal coating elements 400 to expose the upper surfaces 400A of the conductive metal coating elements 400. In the embodiment of Figure 5F, the side walls 230A of the holes 230 are contained within the outer boundaries of the corresponding conductive metal coating elements 400 (see Figure 5E). Further, the side walls 230A of the holes 230 are substantially vertical such that dimensions of openings in the upper surface 108A and the underside surface 108B of the outer dielectric layer 108, corresponding to the holes 230, have substantially the same dimensions. It is noted that in other embodiments, the side walls 230A of the holes 230 may not be substantially vertical.

Figure 5G is the cross-sectional view of the portion of the substrate 102 of Figure 5F, wherein the solderable conductor elements 240 described above have been formed in the holes 230. In the embodiment of Figure 5G, the solderable conductor elements 240 substantially fill the corresponding holes 230, the underside surfaces 240B of the solderable conductor elements 240 are in direct contact with the upper surfaces 400A of the corresponding conductive metal coating elements 400, and the upper surfaces 240A of the solderable conductor elements 240 extend above the upper surface 108A of the outer dielectric layer 108. It is noted that in other embodiments, the upper surfaces 240A of the solderable conductor elements 240 may be even with, or below, the upper surface 108A of the outer dielectric layer 108.

Formed within a corresponding one of the holes 230, each of the solderable conductor elements 240 is contained within the corresponding one of the holes 230. In the embodiment of Figure 5F, the side walls 230A of the holes 230 are contained within the outer boundaries of the corresponding conductive metal coating elements 400 (see Figure 5E). Accordingly, in the embodiment of Figure 5G, each of the solderable conductor elements 240 is contained within an outer boundary of the corresponding one of the conductive metal coating elements 400.

The structures shown in Figure 5G are a fourth embodiment of the compliant bumps 104 of Figure I. As described above, when a body applies a force between the upper surface 240A of one or more of the solderable conductor elements 240 and the substrate 102, the applied force is substantially transmitted to the corresponding compliant bodies 220 (see Figure 5D). In response to the applied force, the compliant bodies 220 deform, providing stress relief to the corresponding I/O pads 200. When the magnitude of the applied force is below a certain level (e.g., a threshold level), the compliant bodies 220 deform in a substantially elastic manner under the applied force. A force is generated within the compliant bodies 220 that opposes the applied force, and maintains physical contact between the one or more solderable conductor elements 240 and the body applying the applied force to the upper surface 240A of the one or more solderable conductor elements 240. When the applied force is removed, the compliant bodies 220 substantially recover to their original sizes and shapes.

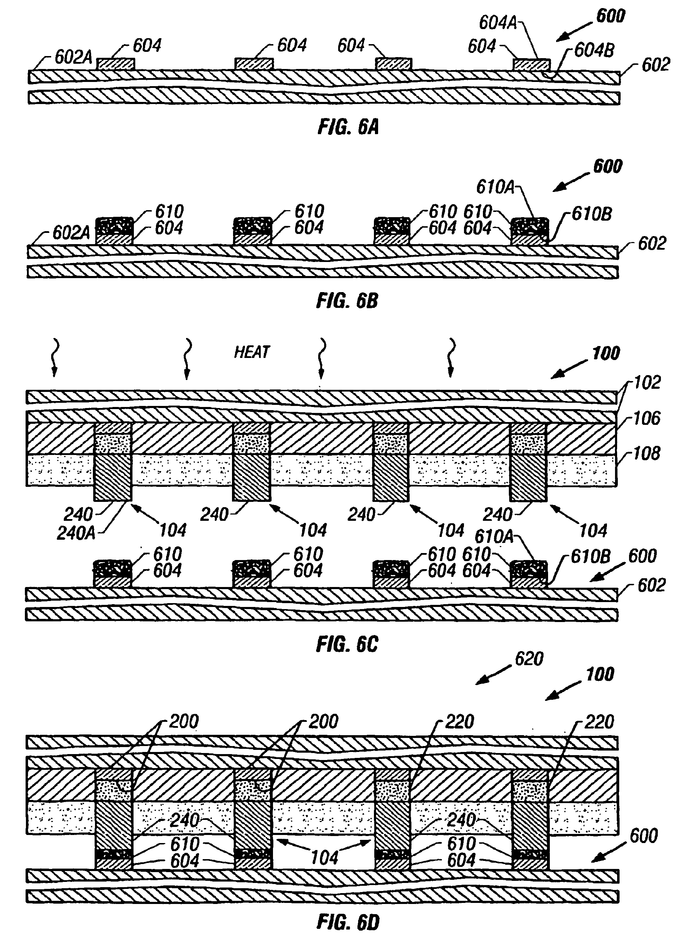

Figures 6A-6D will now be used to describe one embodiment of a method for coupling the semiconductor device 100 of Figure 1 to a first apparatus to form a second apparatus. Figure 6A is a cross-sectional view of a portion of an apparatus 600, wherein the apparatus 600 includes a substrate 602 and multiple bonding pads 604 arranged upon a surface 602A of the substrate 602. For example, the bonding pads 604 may be formed by patterning a layer of a metal (e.g., aluminum or copper) formed on the surface 602A of the substrate 602. Each of the bonding pads 604 has two major surfaces: an upper surface 604A, and an opposed underside surface 604B in contact with the surface 602A of the substrate 602.

Referring back to Figure 1, the arrangement of the bonding pads 604 on the upper surface 602A of the substrate 602 corresponds to (i.e., is a mirror image of) the arrangement of the I/O pads 200 on the upper surface 102A of the substrate 102 of the semiconductor device 100.

The apparatus 600 in Figure 6A may be, for example, an interconnecting apparatus such as a printed circuit board, or a grid array package substrate. In this situation, the substrate 602 may be substantially formed from, for example, a plastic material (e.g., fiberglass epoxy laminate, polyethersulfone, or polyimide), or a ceramic material (e.g., aluminum oxide, alumina, Al₂O₃, or aluminum nitride, AIN). The apparatus 600 may also be part of a multichip module, or a glass liquid crystal display.

Figure 6B is the cross-sectional view of the portion of the apparatus 600 of Figure 6A, wherein solder coating layers 610 have been formed on the upper surfaces 604A of the bonding pads 604 of the apparatus 600. Each of the solder coating layers 610 has an upper surface 610A, and an opposed underside surface 610B in direct contact with the upper surface 604A of a corresponding one of the bonding pads 604. For example, the solder coating layers 610 may be formed on the upper surfaces 604A of the bonding pads 604 by stencil printing solder paste onto the upper surfaces 604A of the bonding pads 604. Alternately, the solder coating layers 610 may be formed on the upper surfaces 604A of the bonding pads 604 by depositing several different layers of constituent metals of a solder alloy on the upper surfaces 604A of the bonding pads 604. Following deposition of the metal layers, the substrate 602 and the bonding pads 604 may be heated to melt the metal layers. The molten metals may mix together to form the solder alloy, and the surface tension of the solder alloy may cause the molten solder alloy to form the solder coating layers 610.

Figure 6C is a cross-sectional view of a portion of one embodiment of the semiconductor device 100 of Figure 1 and the portion of the apparatus 600 of Figure 6B, wherein the portion of the semiconductor device 100 has been inverted and positioned over the portion of the apparatus 600. With the portions of the semiconductor device 100 and the apparatus 600 oriented with respect to one another as shown in Figure 6C, the solderable conductor elements 240 of the compliant bumps 104 of the semiconductor device 100 are positioned directly over the solder coating layers 610 covering corresponding bonding pads 604 of the apparatus 600. In general terms, the semiconductor device 100 and the apparatus 600 are oriented with respect to one another such that the upper surfaces 240A of the solderable conductor elements 240 of the compliant bumps 104 of the semiconductor device 100 are positioned adjacent to the upper surfaces 610A of the solder coating layers 610 covering corresponding bonding pads 604 of the apparatus 600.

As indicated in Figure 6C, once oriented with respect to one another as described above, the semiconductor device 100 and the apparatus 600 are brought together such that the upper surfaces 240A of the solderable conductor elements 240 of the compliant bumps 104 of the semiconductor device 100 contact the upper surfaces 610A of the solder coating layers 610 covering corresponding bonding pads 604 of the apparatus 600. Sufficient heat energy is applied to the substrate 102 of the semiconductor device 100 and/or the substrate 602 of the apparatus 600 to melt (i.e., "reflow") the solder of the solder coating layers 610. When the solder of the solder coating layers 610 cools, the solder mechanically and electrically couples the solderable conductor elements 240 of the compliant bumps 104 of the semiconductor device 100 to the corresponding bonding pads 604 of the apparatus 600.

Figure 6D is a cross-sectional view of the portions of the semiconductor device 100 and the apparatus 600 of Figure 6B following the coupling operation of Figure 6C, wherein the portions of the semiconductor device 100 and the apparatus 600 have been joined to form an apparatus 620. In the apparatus 620, the I/O pads 200 of the semiconductor device 100 are electrically coupled to the corresponding bonding pads 604 of the apparatus 600 via the compliant bumps 104 and the solder coating layer 610 connections, wherein the compliant bumps 104 include the compliant bodies 220 and the solderable conductor elements 240.

The presence of the compliant bodies 220 in the compliant bumps 104 of the semiconductor device 100 reduces mechanical stresses created in the solder coating layer 610 connections due to differences in the coefficients of thermal expansion (CTEs) of the substrate 102 of the semiconductor device 100 and the substrate 602 of the apparatus 600. As described above, such mechanical stresses are created during solder reflow operations (e.g., the solder reflow operation depicted in Figure 6C and described above), and during thermal cycling resulting from on-off operation of the semiconductor device 100 following attachment of the semiconductor device 100 to the substrate 602 of the apparatus 600. As a result of the reduced mechanical stresses in the solder coating layer 610 connections, the solder coating layer 610 connections may not fatigue and fail as rapidly as typical solder coating layer connections. In this situation, the reliabilities of the solder coating layer 610 connections are expectedly increased over typical solder coating layer connections.

The particular embodiments disclosed above are illustrative only, as the invention may be modified and practiced in different but equivalent manners apparent to those skilled in the art having the benefit of the teachings herein. Furthermore, no limitations are intended to the details of construction or design herein shown, other than as described in the claims below. It is therefore evident that the particular embodiments disclosed above may be altered or modified and all such variations are considered within the scope of the invention. Accordingly, the protection sought herein is as set forth in the claims below.

## Claims

1. A semiconductor device (100), comprising:
a plurality of input/output (I/O) pads (200) arranged on a surface of a semiconductor substrate (102);
an outer dielectric layer (108) having a plurality of openings (230) extending therethrough;
a compliant dielectric layer (106) positioned between the outer dielectric layer (108) and the surface (102A) of the semiconductor substrate (102) and having a plurality of openings (210) extending therethrough, wherein said compliant dielectric layer (106) comprises a polymer-based material;
a plurality of electrically conductive, compliant bumps (104), wherein each of the compliant bumps (104) is formed upon, and corresponds to a different one of the I/O pads (200), and wherein each of the compliant bumps (104) extends through a different one of the openings (210, 230) in the compliant dielectric layer (106) and the outer dielectric layer (108), and wherein each of the compliant bumps (104) comprises:
an electrically conductive, solderable conductor element (240), wherein the solderable conductor element (240) is solder wettable; and
an electrically conductive, compliant body (220) positioned between the solderable conductor element (240) and a corresponding one of the I/O pads (200) wherein the compliant body (220) electrically couples the solderable conductor element (240) to the corresponding one of the I/O pads (200).

2. The semiconductor device (100) as recited in claim 1, wherein the semiconductor device (100) is a chip scale package (CSP).

3. The semiconductor device (100) as recited in claim 1, wherein the solderable conductor element (240) of each of the compliant bumps (104) comprises at least one metal selected from the group consisting of: lead, tin, cadmium, indium, bismuth, gallium, copper, silver, platinum, palladium, nickel, and gold.

4. The semiconductor device (100) as recited in claim 1, wherein the solderable conductor element (240) of each of the compliant bumps (104) comprises an alloy including at least two metals selected from the group consisting of: lead, tin, cadmium, indium, bismuth, and gallium.

5. The semiconductor device (100) as recited in claim 1, wherein the compliant body (220) of each of the compliant bumps (104) forms a flexible, electrically conductive path between the solderable conductor element (240) and the electrical conductor.

6. The semiconductor device (100) as recited in claim 1, wherein a shape of each of the complaint bumps (104) changes from an original shape to an altered shape when the compliant bump (104) is subjected to a force exerted between the solderable conductor element (240) and the electrical conductor, and wherein the shape of each of the compliant bumps (104) substantially reverts to the original shape when the force is removed.

7. The semiconductor device (100) as recited in claim 1, wherein the compliant body (220) of each of the compliant bumps (104) comprises a polymer based material.

8. The semiconductor device (100) as recited in claim 7, wherein the polymer based material comprises epoxy, silicone, polyimide, acrylate polymers, or acrylate copolymers.

9. The semiconductor device (100) as recited in claim 7, wherein the compliant body (220) of each of the compliant bumps (104) further comprises at least one filler material selected from the group consisting of: silver, gold, and palladium, wherein the at least one filler material is used to increase the electrical conductivity of the compliant body (220).

10. The semiconductor device (100) as recited in claim 1, wherein the compliant body (220) of each of the compliant bumps (104) has a volume resistivity of less than or equal to about 0.001 ohm-cm.

11. The semiconductor device (100) as recited in claim 1, wherein the compliant body (220) of each of the compliant bumps (104) has a volume resistivity of less than or equal to approximately 0.0001 ohm-cm.

12. The semiconductor device (100) as recited in claim 1, wherein the compliant body (220) of each of the compliant bumps (104) has a Young's modulus of less than or equal to about 8,000 MPa.

13. The semiconductor device (100) as recited in claim 1, wherein the compliant body (220) of each of the compliant bumps (104) has a Young's modulus of less than or equal to approximately 1,000 MPa.

14. The semiconductor device (100) as recited in claim 1, wherein each of the I/O pads (200) is used to convey electrical power or an electrical signal to or from the semiconductor device (100), and wherein the compliant bumps (104) form electrical terminals of the semiconductor device (100).

15. The semiconductor device (100) as recited in claim 1, wherein the compliant body (220) of a given one of the compliant bumps (104) is in direct contact with the corresponding one of the I/O pads (200) and the solderable conductor element (240) of the given one of the compliant bumps (104).

16. The semiconductor device (100) as recited in claim 1, wherein the openings (210, 230) in the compliant dielectric layer and the outer dielectric layer (108) correspond to positions of the I/O pads (200) on the surface of the semiconductor substrate (102).

17. The semiconductor device (100) as recited in claim 1, wherein the compliant dielectric layer (106) provides stress relief for the outer dielectric layer (108) and the surface or the semiconductor substrate (102).

18. The semiconductor device (100) as recited in claim 1, wherein when a force is applied to a surface (108A, 108B) of the outer dielectric layer (108) opposite the compliant dielectric layer (106) the force is substantially transmitted to the compliant dielectric layer (106), and wherein in response to the force, the compliant dielectric layer (106) deforms, allowing the outer dielectric layer (108) to move in relation to the surface of the semiconductor substrat (102).

19. The semiconductor device (100) as recited in claim 1, wherein the polymer based material comprises epoxy, silicone, polyimide, acrylate polymers, or acrylate copolymers.

20. The semiconductor device (100) as recited in claim 1, wherein the compliant dielectric layer (106) has a volume resistivity of greater than or equal to about 1.0 x 10¹⁰ ohm-cm.

21. The semiconductor device (100) as recited in claim 1, wherein the compliant dielectric layer (106) has a volume resistivity of greater than or equal to approximately 1.0 x 10¹⁵ ohm-cm

22. The semiconductor device (100) as recited in claim 1, wherein the compliant dielectric layer (106) has a Young's modulus of less than or equal to about 8,000 Mpa.

23. The semiconductor device (100) as recited in claim 1, wherein the compliant dielectric layer (106) has Young's modulus of less than or equal to approximately 1,000 MPa.

24. The semiconductor device (100) as recited in claim 1, wherein the outer dielectric layer (108) provides mechanical protection for the compliant dielectric layer (106) and the surface of the semiconductor substrate (102).

25. The semiconductor device (100) as recited in claim 1, wherein when a force is applied to a surface of the outer dielectric layer (108) opposite the compliant dielectric layer (106), the outer dielectric layer (108) deforms to a lesser extent than the compliant dielectric layer (106), and serves to distribute the force over a relatively wide area of the compliant dielectric layer (106).

26. The semiconductor device (100) as recited in claim 1, wherein the outer dielectric layer (108) comprises a polymer based material.

27. The semiconductor device (100), as recited in claim 26, wherein the polymer based material comprises epoxy, silicone, polyimide, acrylate polymers, or acrylate copolymers.

28. The semiconductor device (100) as recited in claim 1, wherein the outer dielectric layer (108) comprises an inorganic dielectric material.

29. The semiconductor device (100) as recited in claim 28, wherein the inorganic dielectric material is selected from the group consisting of silicon dioxide (SiO₂) and silicon nitride (Si₃N4).

30. The semiconductor device (100) as recited in claim 1, wherein the outer dielectric layer (108) has a volume resistivity of greater than or equal to about 1.0 x 10¹⁰ ohm-cm.

31. The semiconductor device (100) as recited in claim 1, wherein the outer dielectric layer (108) has a volume resistivity of greater than or equal to approximately 1.0x10¹⁵ ohm-cm.

32. The semiconductor device (100) as recited in claim 1, wherein the outer dielectric layer (108) has a Young's modulus which is greater than a Young's modulus of the compliant dielectric layer.

33. The semiconductor device (100) as recited in claim 1, wherein the outer dielectric layer (108) has a Young's modulas which is at least twice a Young's modulus of the compliant dielectric layer.

34. A method for forming a semiconductor device (100) according to claim 1, comprising:
forming a compliant dielectric layer (106) comprises of a polymer-based material (102) over a surface of a semiconductor substrate, wherein a plurality of input/output (I/O) pads (200) are arranged upon the surface of the semiconductor substrate (102), and wherein the compliant dielectric layer (106) has a plurality of openings (210) extending therethrough, and wherein each of the opening (230) exposes a different one of the I/O pads (200);
forming an electrically conductive, compliant body (220) in each of the opening (210) of the compliant dielectric layer (106) such that each of the compliant bodies (220) is electrically coupled to the I/O pad (200) exposed by the corresponding opening (210);
forming an outer dielectric layer (108) over the compliant dielectric layer (106), wherein the outer dielectric layer (108) has a plurality of openings (230) extending therethrough, and wherein each of the openings (230) exposes a different one of the compliant bodies (220); and
forming an electrically conductive, solderable conductor element (240) in each of the openings (230) ot the outer dielectric layer (108) such that each of the solderable conductor elements (240) is electrically coupled to the compliant body (220) exposed by the corresponding opening and wherein each of the solderable conductor elements (240) is solder wettable.

35. The method as recited in claim 34, wherein the forming of the electrically conductive, compliant body (220) in each of the openings of the compliant dielectric layer (106) comprises
forming an electrically conductive, compliant body (220) in each of the openings (210) of the compliant dielectric layer (106) such that an underside surface (220B) of each of the compliant bodies (220) is in direct contact with an upper surface (200A) of the I/O pad (200) exposed by the corresponding opening (210) and is thereby electrically complet to the I/O pad (200) exposed by the corresponding opening (210).

36. The method as recited in claim 34, wherein the forming of the electrically conductive, solderable conductor element (240) in each of the openings (230) of the dielectric layer (108) comprises:
forming an electrically conductive, solderable element (240) in each of the opening (230) of the outer dielectric layer (108) such that an underside surface (240B) of each of the solderable conductor elements (240) is in direct contact with an upper surface (220A) of the compliant body (220) exposed by the corresponding opening, and is thereby electrically coupled to the complient body (220) exposed by the corresponding opening (230) and wherein each of the solderable conductor elements (240) comprises at least one metal selected from the group consisting of lead, tin, cadmium, indium, bismuth, gallium, copper, silver, platinum, palladium, nicklel, and gold.

37. A method for forming a embodiment device (100) according to claim 1, comprising:
forming an electrically conductive metal coating element (300) over each of plurality of input/output (I/O) pads (200) arranged on a surface of a semiconductor substrate (102), wherein outer boundaries of the conductive metal coating elements (300) extend beyond outer boundaries of the corresponding I/O pads (200), and wherein the conductive metal coating elements (300) function as adhesion layers, barries layers, or both adhesion layers and barrier layers;
forming a compliant dielectric layer (106) comprised of a polymer-based material over the surface of the semiconducteur substrate (102) wherein the compliant dielectric layer (106) has a plurality of openings extending (230) therethrough and wherein each of the openings (230) exposes a different one of the conductive metal coating elements (300);
forming an electrically conductive, compliant body (220) in each of the openings of the compliant dielectric layer (106) such that each of the compliant bodies (220) is electrically coupled to the conductive metal coating element (300) exposed by the corresponding opening (210);
forming an outer dielectric layer (108) over the compliant dielectric layer (106) wherein the outer dielectric layer (108) has a plurality of openings (230) extending therethrough, and wherein each of the openins (230) exposes a different one of the compliant bodies (220); and
forming an electrically conductive, solderable conductor element (240) in each of the openings (230) of the outer dielectric layer (108) such that each of the solderable conductor elements (240) is electrically coupled to the compliant body (220) exposed by the corresponding opening (230) and wherein each of the solderable conductor elements (240) is solder wettable.

38. The method as recited in claim 37, wherein the forming of the electrically conductive metal coating element (300) over each of the plurality of input/output (I/O) pads (200) comprises:
forming an electrically conductive metal coating element (300) over each of a plurality of input/output (I/O) pads (200) arranged on a surface of a semiconductor substrate (102), wherein outer boundaries of the conductive metal coating elements (300) extend beyond outer boundaries of the corresponding I/O pads (200) and wherein the conductive metal coating elements (300) function as adhesion layers, barrier layers, or both adhesion layers and barrier layers, and wherein each of the conductive metal coating elements (300) comprises at least one layer of a metal selected from the group consisting of: chrome, copper gold, silver, titanium, and tungsten.

39. The method as recited in claim 37, wherein the forming of the electrically conductive, solderable conductor element (240) in each of the opening (230) of the outer dielectric layer (108) comprises:
forming an electrically conductive, solderable conductor element (240) in each of the openings (230) of the outer dielectric layer (108) such that each of the solderable conductor elements (240) is electrically compled to the compliant body (220) exposed by the corresponding opening (230) and wherein each of the solderable conductor elements (240) is solder wettable, and wherein each of the solderable conductor elements (240) comprises at least one metal selected from the group consisting of lead, tin, cadmium, indium, bismuth, gallium, copper, silver, platinum, palladium, nickel, and gold.

40. A method for forming a semiconductor device (100) according to claim 9, comprising:
forming a compliant dielectric layer (106) comprised of a polymer-based material (102) over a surface of a semiconductor substrate, wherein the compliant dielectric layer (106) has a plurality of openings (210) extending therethrough, and wherein each of the openings (210) exposes a different aus of a plurality of input/output (I/O) pads (200) arranged on the surface of the semiconductor substrate (102);
forming an electricallly conductive, compliant body (220) in each of the openings (220) of the compliant dielectric layer (106) such that each of the compliant bodies (220) is electrically coupled to the first conductive metal coating element (240) exposed by the corresponding opening (210);
forming an electrically conductive metal coating element (400) over each of the compliant bodies (220), wherein the conductive metal coating elements (240) substantially cover the compliant bodies (220) and function as adhesion layers, barrier layers, or both adhesion layers and barrier layers;
forming an outer dielectric layer (108) over the compliant dielectric layer (106), wherein the outer dielectric layer (108) has a plurality of openings (230) extending therethrough, and wherein each of the openings (230) exposes a different one of the conductive metal coating elements (240); and
forming an electrically conductive, solderable conductor element in (240) each of the openings (230) of the outer dielectric layer (108) such that each of the solderable conductor elements (240) electrically coupled to the conductive metal coating element (400) exposed by the corresponding opening (230), and wherein each of the solderable conductor elements (240) is solder wettable.

41. The method as recited in claim 40, wherein the forming of the electrically conductive metal coating element (400) over each of the compliant bodies (220) comprises:
forming an electrically conductive metal coating element (400) over each of the compliant bodies (220), wherein the conductive metal coating elements (400), substantially cover the complaint bodies (220) and function as adhesion layers, barrier layers, or both adhesion layers and barrier layers, and wherein each of the conductive metal coating elements (400) comprises at least one layer of a metal selected from the group consisting of chrome, copper, gold, silver, titanium, and tungsten.

42. The method as recited in claim 40, wherein the forming of the electrically conductive, solderable conductor element (240) in each of the opening of the outer dielectric layer (108) comprises:
forming an electrically conductive, solderable conductor element (240) in each of the openings (230) of the outer dielectric layers (108) such that each of the solderable conductor elements (240) is electrically coupled to the conductive metal coating element (400) exposed by the corresponding opening (230), and wherein each of the solderable conductor elements (240) is solder wettable, and wherein each of the solderable conductor elements (240) comprises at least one metal selected from the group consisting of: lead, tin, cadmium, indium, bismuth, gallium, copper, silver, platinum, palladium, nickel, and gold.

43. A method for forming a semiconductor device (100) according to claim 1, comprising:
forming a first electrically conductive metal coating element (300) over each of a plurality of input/output (I/O) pads (200) arranged on a surface of a semiconductor substrate (102), wherein outer boundaries of the conductive metal coating elements (300) extend beyond outer boundaries of the corresponding I/O pads (200), and wherein the conductive metal coating elements (300) function as adhesion layers, barrier layers, or both adhesion layers and barrier layers;
forming a compliant dielectric layer (106) comprised of a polymer-based material over the surface of the semiconductor substrate (102), wherein the compliant dielectric layer (106) has a plurality of openings (210) extending therethrough, and wherein each of the openings (210) exposes a different one of the first conductive metal coating elements (300);
forming an electrically conductive, compliant body (220) in each of the openings (210) of the compliant dielectric layer (106) such that each of the compliant bodies (220) is electrically coaled to the first conductive metal coating element (300) exposed by the corresponding opening (210);
forming a second electrically conductive metal coating element (400) over each of the compliant bodies (220), wherein the second conductive metal coating elements (400) substantially cover the complaint bodies (220) and function as adhesion layers, barrier layers, or both adhesion layers and barrier layers;
forming an outer dielectric layer (108) over the compliant dielectric layer (106), wherein the outer dielectric layer has a plurality of openings (230) extending therethrough, and wherein each of the openings (230) exposes a different one of the second conductive metal coating elements (400); and
forming an electrically conductive, solderable conductor element (240) in each of the opening (230) of the outer dielectric layer (108), such that each of the solderable conductor elements (240) is electrically coupled to the second conductive metal coating element (400) exposed by the corresponding opening (230), and wherein each of the solderable conductor elements (240) is solder wettable.

44. The method as recited in claim 43, wherein the forming of the first electrically conductive metal coating element (300) over each of the plurality of input/output (I/O) pads (200) comprises:
forming a first electrically conductive metal coating element (300) over each of a plurality of imput/output (I/O) parts (200) arranged on a surface of a semiconductor substrate (102), wherein outer boundaries of the conductive metal coating elements (300) extend beyond outer boundaries of the corresponding I/O pads (200) and wherein the first conductive metal coating elements (300) function as adhesion layers, bander layers. or both adhesion layers and barrier layers, and wherein each of the first conductive metal coating elements (300) comprise at least one layer of a metal selected from the group consisting of: chrome, copper, gold, solver, titanium, and tungsten.

45. The method as recited in claim 43, wherein the forming of the second electrically conductive metal coating element (400) each of the compliant bodies (220) comprises
forming a second electrically conductives metal coating element (400) over each of the compliant bodies (220), wherein the second conductive metal coating elements (400) substantially cover the compliant bodies (220) and function as adhesion layers, barrier layers, or both adhesion layers and barrier layers, and wherein each of the second conductive metal coating elements (400) comprises at least one layer of metal selected from the group consisting of: chrome, copper, gold, silver, titanium, and tungsten.

46. The method as recited in claim 43, wherein the forming of the electrically conductive, solderable conductor element (240) in each of the openings (230) of the outer dielectric layer (108) comprises:
forming an electrically conductive, solderable conductor element (240) in each of the openings (230) of the outer dielectric layer (108) such that each of the solderable conductor elements (240) is electrically coupled to the second conductive metal coating element (400) exposed by the corresponding opening (230) and wherein each of the solderable conductor elements (240) is solder wettable, and wherein each of the solderable conductor elements (240) comprises at least one metal selected from the group consisting of: lead, tin, cadinium, indium, bismuth, gallium, copper, silver, platinum, palladium, nickel, and gold.

47. An apparatus (600), comprising:
a component comprising a substrate (602) and a plurality of bonding pads (604) arranged upon a surface (602A) of the substrate (602), wherein the bonding pads are arranged according to a first pattern;
a semiconductor device (100) according to any one of claims 1-33, wherein the I/O pads (200) are arranged on the surface of the semi-conductor substrate (102) according to a second pattern and wherein the second pattern is substantially the same as the first pattern; and
wherein the bonding pads (604) of the component (600) are adjacent to, and electrically coupled to, the I/O pads (200) of the semiconductor device (100).

48. The apparatus as recited in claim 47, wherein the semiconductor device (100) is a chip seale

49. The apparatus as recited in claim 47, wherein the substrate (602) of the component (600) comprises a plastic material.

50. The apparatus (600) as recited in claim 47, wherein the substrate (602) of the component comprises a ceramic material.

51. The apparatus (600) as recited in claim 47, wherein the second pattern is a mirror image of the first pattern.

52. A method for forming an apparatus, comprising:
providing a component comprising a substrate (602) and a plurality of bonding pads (604) arranged upon a surface (602A) of the substrate (602), wherein the bonding pads are are arranged according to a first pattern;
providing a semiconductor device (100) according to any one of claims 1-33, wherein the I/O pads are arranged on the surface of the semi-conductor substrate (102) according to a second pattern, and wherein the second pattern is substantially the same as the first pattern;
forming a solder coating layer (610) on each of the bonding pads (604) of the component bringing the I/O pads (200) of the semiconductor device (100) into contact with the solder coating layers (610) formed on the bonding pads (604) of the component and
heating the substrate (602), of the component or the semiconductor (102) of the semiconductor device (100) until the solder coating layers melt.

53. The method as recited in claim 52, wherein the providing of the semiconductor device (100) comprises:
providing a semiconductor device (100) comprising:
a semiconductor substrate (102) and a plurality of input/output (I/O) pads (200) arranged on a surface (102A) of the semiconudctor substante (102) wherein the I/D pads (200) are arranged according to a second pattern, and wherein the second pattern is a mirror image of the first pattern.

## Revendications

1. Dispositif à semi-conducteur (100), comprenant :
une pluralité de plots d'entrée/sortie (E/S) (200) disposés sur une surface d'un substrat semi-conducteur (102) ;
une couche diélectrique extérieure (108) comportant une pluralité d'orifices (230) s'étendant à travers elle ;
une couche diélectrique souple (106) disposée entre la couche diélectrique extérieure (108) et la surface (102A) du substrat semi-conducteur (102), et comportant une pluralité d'orifices (210) s'étendant à travers elle, ladite couche diélectrique souple (106) étant en matériau à base de polymère ;
une pluralité de bosses souples et électro-conductrices (104), chacune des bosses souples (104) étant formée sur et correspondant à un des différents plots d'entrée/sortie (200), et dans laquelle chacune des bosses souples (104) s'étend à travers un des différents orifices (210, 230), dans la couche diélectrique souple (106) et dans la couche diélectrique extérieure (108), et dans laquelle chacune des bosses souples (104) est constituée par :
un élément conducteur soudable et électro-conducteur (240), l'élément conducteur soudable (240) étant mouillable par le matériau de soudage ; et
un corps souple électro-conducteur (220) disposé entre l'élément conducteur soudable (240) et un des plots d'entrée/sortie lui correspondant (200) ; dans lequel le corps souple (220) couple électriquement l'élément conducteur soudable (240) au plot d'entrée/sortie (200) lui correspondant.

2. Dispositif à semi-conducteur (100) selon la revendication 1, dans lequel le dispositif à semi-conducteur (100) est un boîtier-puce (CSP).

3. Dispositif à semi-conducteur (100) selon la revendication 1, dans lequel l'élément conducteur soudable (240) de chacune des bosses souples (104) comprend au moins un métal sélectionné parmi un groupe constitué de : plomb, étain, cadmium, indium, bismuth, gallium, cuivre, argent, platine, palladium, nickel, et or.

4. Dispositif à semi-conducteur (100) selon la revendication 1, dans lequel l'élément conducteur soudable (240) de chacune des bosses souples (104) comprend un alliage constitué d'au moins deux métaux sélectionnés parmi un groupe constitué de : plomb, étain, cadmium, indium, bismuth, et gallium.

5. Dispositif à semi-conducteur (100) selon la revendication 1, dans lequel le corps souple (220) de chacune des bosses souples (104) constitue un chemin électro-conducteur souple entre l'élément conducteur soudable (240) et le conducteur électrique.

6. Dispositif à semi-conducteur (100) selon la revendication 1, dans lequel la forme de chacune des bosses souples (104) change d'une forme initiale en une forme modifiée lorsque la bosse souple (104) est soumise à une force exercée entre l'élément conducteur soudable (240) et le conducteur électrique, et dans lequel la forme de chacune des bosses souples (104) revient sensiblement à sa forme initiale lorsque la force cesse.

7. Dispositif à semi-conducteur (100) selon la revendication 1, dans lequel le corps souple (220) de chacune des bosses souples (104) est en matériau à base de polymère.

8. Dispositif à semi-conducteur (100) selon la revendication 7, dans lequel le matériau à base de polymère comprend de l'époxy, de la silicone, du polyimide, des polymères acryliques, ou des copolymères acryliques.

9. Dispositif à semi-conducteur (100) selon la revendication 7, dans lequel le corps souple (220) de chacune des bosses souples (104) comprend en outre au moins un matériau de remplissage sélectionné parmi un groupe constitué de : argent, or, et palladium, dans lequel ledit au moins un matériau de remplissage est utilisé pour augmenter la conductivité électrique du corps souple (220).

10. Dispositif à semi-conducteur (100) selon la revendication 1, dans lequel le corps souple (220) de chacune des bosses souples (104) présente une résistivité volumique inférieure ou égale à environ 0,001 ohm-cm.

11. Dispositif à semi-conducteur (100) selon la revendication 1, dans lequel le corps souple (220) de chacune des bosses souples (104) présente une résistivité volumique inférieure ou égale à environ 0,0001 ohm-cm.

12. Dispositif à semi-conducteur (100) selon la revendication 1, dans lequel le corps souple (220) de chacune des bosses souples (104) présente un module d'élasticité de Young inférieur ou égal à environ 8.000 MPa.

13. Dispositif à semi-conducteur (100) selon la revendication 1, dans lequel le corps souple (220) de chacune des bosses souples (104) présente un module d'élasticité de Young inférieur ou égal à environ 1.000 MPa.

14. Dispositif à semi-conducteur (100) selon la revendication 1, dans lequel chacun des plots d'entrée/sortie (200) est utilisé pour transporter le courant électrique ou un signal électrique vers ou depuis le dispositif à semi-conducteur (100), et dans lequel les bosses souples (104) forment des bornes électriques du dispositif à semi-conducteur (100).

15. Dispositif à semi-conducteur (100) selon la revendication 1, dans lequel le corps souple (220) d'une bosse souple donnée (104) est en contact direct avec le plot d'entrée-sortie correspondant (200) et l'élément conducteur soudable (240) de la bosse souple donnée (104).

16. Dispositif à semi-conducteur (100) selon la revendication 1, dans lequel les orifices (210, 230) ménagés dans la couche diélectrique souple et dans la couche diélectrique extérieure (108) sont en correspondance avec des emplacements de plots d'entréelsortie (200) sur la surface du substrat semi-conducteur (102).

17. Dispositif à semi-conducteur (100) selon la revendication 1, dans lequel la couche diélectrique souple (106) procure une relaxation de contrainte pour la couche diélectrique extérieure (108) et la surface du substrat semi-conducteur (102).

18. Dispositif à semi-conducteur (100) selon la revendication 1, dans lequel lorsqu'une force est exercée sur une surface (108A, 108B) de la couche diélectrique extérieure (108) faisant face à la couche diélectrique souple (106), la force est sensiblement transmise à la couche diélectrique souple (106), et dans lequel, en réponse à la force, la couche diélectrique souple (106) se déforme, permettant à la couche diélectrique extérieure (108) de se déplacer par rapport à la surface du substrat semi-conducteur (102).

19. Dispositif à semi-conducteur (100) selon la revendication 1, dans lequel le matériau à base de polymère comprend de l'époxy, de la silicone, du polyimide, des polymères acryliques, ou des copolymères acryliques.

20. Dispositif à semi-conducteur (100) selon la revendication 1, dans lequel la couche diélectrique souple (106) présente une résistivité volumique supérieure ou égale à environ 1,0x10¹⁰ ohm-cm.

21. Dispositif à semi-conducteur (100) selon la revendication 1, dans lequel la couche diélectrique souple (106) présente une résistivité volumique supérieure ou égale à environ 1,0x10¹⁵ ohm-cm.

22. Dispositif à semi-conducteur (100) selon la revendication 1, dans lequel la couche diélectrique souple (106) présente un module d'élasticité de Young inférieur ou égal à environ 8.000 MPa.

23. Dispositif à semi-conducteur (100) selon la revendication 1, dans lequel la couche diélectrique souple (106) présente un module d'élasticité de Young inférieur ou égal à environ 1.000 MPa.

24. Dispositif à semi-conducteur (100) selon la revendication 1, dans lequel la couche diélectrique extérieure (108) offre une protection mécanique pour la couche diélectrique souple (106) et la surface du substrat semi-conducteur (102).

25. Dispositif à semi-conducteur (100) selon la revendication 1, dans lequel lorsqu'une force est exercée sur une surface de la couche diélectrique extérieure (108) faisant face à la couche diélectrique souple (106), la couche diélectrique extérieure (108) se déforme dans une moindre mesure que la couche diélectrique souple (106) et sert à répartir la force sur une surface relativement large de la couche diélectrique souple (106).

26. Dispositif à semi-conducteur (100) selon la revendication 1, dans lequel la couche diélectrique extérieure (108) est en matériau à base de polymère.

27. Dispositif à semi-conducteur (100) selon la revendication 26, dans lequel le matériau à base de polymère comprend de l'époxy, de la silicone, du polyimide, des polymères acryliques, ou des copolymères acryliques.

28. Dispositif à semi-conducteur (100) selon la revendication 1, dans lequel la couche diélectrique extérieure (108) est en matériau diélectrique inorganique.

29. Dispositif à semi-conducteur (100) selon la revendication 28, dans lequel le matériau diélectrique inorganique est sélectionné parmi le groupe constitué de l'oxyde de silicium (SiO₂) et du nitrure de silicium (Si₃N₄).

30. Dispositif à semi-conducteur (100) selon la revendication 1, dans lequel la couche diélectrique extérieure (108) présente une résistivité volumique supérieure ou égale à environ 1,0x10¹⁰ ohm-cm.

31. Dispositif à semi-conducteur (100) selon la revendication 1, dans lequel la couche diélectrique extérieure (108) présente une résistivité volumique supérieure ou égale à environ 1,0x10¹⁵ ohm-cm.

32. Dispositif à semi-conducteur (100) selon la revendication 1, dans lequel la couche diélectrique extérieure (108) présente un module d'élasticité de Young supérieur au module de Young de la couche diélectrique souple.

33. Dispositif à semi-conducteur (100) selon la revendication 1, dans lequel la couche diélectrique extérieure (108) présente un module d'élasticité de Young au moins deux fois supérieur au module de Young de la couche diélectrique souple.

34. Procédé de fabrication d'un dispositif à semi-conducteur (100) conforme à la revendication 1, comprenant les étapes suivantes :
former une couche diélectrique souple (106) en matériau à base de polymère sur une surface d'un substrat semi-conducteur (102), une pluralité de plots d'entréelsortie (E/S) (200) étant disposés sur la surface du substrat semi-conducteur (102), et la couche diélectrique souple (106) comportant une pluralité d'orifices (210) s'étendant à travers elle, et chacun des orifices (210) exposant un plot d'entrée/sortie différent (200) ;
former un corps souple électro-conducteur (220) dans chacun des orifices (210) de la couche diélectrique souple (106) de telle manière que chacun des corps souples (220) soit couplé électriquement au plot d'entrée/sortie (200) exposé par l'orifice correspondant (210) ;
former une couche diélectrique extérieure (108) sur la couche diélectrique souple (106), la couche diélectrique extérieure (108) comportant une pluralité d'orifices (230) s'étendant à travers elle, et chacun des orifices (230) exposant un corps souple (220) différent ;
et
former un élément électro-conducteur soudable (240) dans chacun des orifices (230) de la couche diélectrique extérieure (108), de telle manière que chacun des éléments conducteurs soudables (240) soit couplé électriquement au corps souple (220) exposé par l'orifice correspondant, chaque élément conducteur soudable (240) étant mouillable par le matériau de soudage.

35. Procédé selon la revendication 34, dans lequel la formation du corps souple électro-conducteur (220) dans chacun des orifices de la couche diélectrique souple (106) comprend les étapes suivantes :
former un corps souple électro-conducteur (220) dans chacun des orifices (210) de la couche diélectrique souple (106) de telle manière qu'une surface inférieure (220B) de chacun des corps souples (220) soit en contact direct avec une surface supérieure (200A) du plot d'E/S (200) exposé par l'orifice correspondant (210) et soit ainsi couplée électriquement au plot d'E/S (200) exposé par l'orifice correspondant (210).

36. Procédé selon la revendication 34, dans lequel la formation de l'élément électro-conducteur soudable (240) dans chacun des orifices (230) de la couche diélectrique extérieure (108) comprend les étapes suivantes :
former un élément électro-conducteur soudable (240) dans chacun des orifices (230) de la couche diélectrique extérieure (108) de telle manière qu'une surface inférieure (200B) de chacun des éléments électro-conducteurs soudables (240) soit en contact direct avec une surface supérieure (220A) du corps souple (220) exposé par l'orifice correspondant, chacun des éléments électro-conducteurs soudables (240) comprenant au moins un métal parmi le groupe constitué de : plomb, étain, cadmium, indium, bismuth, gallium, cuivre, argent, platine, palladium, nickel, et or.

37. Procédé pour former un dispositif à semi-conducteur (100) conforme à la revendication 1, comprenant les étapes suivantes :
former un élément de revêtement métallique électro-conducteur (300) sur chacune d'une pluralité de plots d'entrée/sortie (E/S) (200) disposés sur une surface d'un substrat semi-conducteur (102), dans lequel les contours extérieurs des éléments de revêtement métallique conducteurs (300) s'étendent au-delà des contours extérieurs des plots d'E/S correspondants (200), les éléments de revêtement métallique conducteurs (300) faisant office de couches d'adhérence, de couches d'arrêt ou à la fois de couches d'adhérence et d'arrêt ;
former une couche diélectrique souple (106) en matériau à base de polymère sur la surface du substrat semi-conducteur (102), la couche diélectrique souple (106) comportant une pluralité d'orifices (210) s'étendant à travers elle, et chacun des orifices (210) exposant un élément de revêtement métallique conducteur différent (300) ;
former un corps souple électro-conducteur (220) dans chacun des orifices de la couche diélectrique souple (106) de telle manière que chacun des corps souples (220) soit couplé électriquement à l'élément de revêtement métallique conducteur (300) exposé par l'orifice correspondant (210) ;
former une couche diélectrique extérieure (108) sur la couche diélectrique souple (106), la couche diélectrique extérieure (108) comportant une pluralité d'orifices (230) s'étendant à travers elle, et dans laquelle chacun des orifices (230) expose un corps souple (220) différent ;
et
former un élément conducteur soudable, électro-conducteur, (240) dans chacun des orifices (230) de la couche diélectrique extérieure (108), de telle manière que chacun des éléments conducteurs soudables (240) soit couplé électriquement au corps souple (220) exposé par l'orifice correspondant (230), chaque élément conducteur soudable (240) étant mouillable par le matériau de soudage.

38. Procédé selon la revendication 37, dans lequel la formation de l'élément de revêtement métallique électro-conducteur (30) sur chacun des plots d'entrée/sortie (E/S) comprend les étapes suivantes :
former un élément de revêtement métallique électro-conducteur (300) sur chacune d'une pluralité de plots d'entrée/sortie (E/S) (200) disposés sur une surface d'un substrat semi-conducteur (102), dans lequel les contours extérieurs des éléments de revêtement métallique conducteur (300) s'étendent au-delà des contours extérieurs des plots d'E/S correspondants (200), et dans lequel les éléments de revêtement métallique conducteurs (300) font office de couches d'adhérence, de couches d'arrêt ou à la fois de couches d'adhérence et d'arrêt, chacun des éléments de revêtement métallique conducteurs (300) comprenant au moins une couche d'un métal sélectionné parmi le groupe constitué de : chrome, cuivre, or, argent, titane, et tungstène.

39. Procédé selon la revendication 37, dans lequel la formation de l'élément conducteur soudable, électro-conducteur (240) dans chacun des orifices (230) de la couche diélectrique extérieure (108) comprend les étapes suivantes :
former un élément conducteur soudable, électro-conducteur (240) dans chacun des orifices (230) de la couche diélectrique extérieure (108) de telle manière que chacun des éléments conducteurs soudables (240) soit couplé électriquement au corps souple (220) exposé par l'orifice correspondant (230), chacun des éléments conducteurs soudables (240) étant mouillable par le matériau de soudage, et chacun des éléments conducteurs soudables (240) comprenant au moins un métal sélectionné parmi un groupe constitué de : plomb, étain, cadmium, indium, bismuth, gallium, cuivre, argent, platine, palladium, nickel, et or.

40. Procédé de fabrication d'un dispositif à semi-conducteur (100) conforme à la revendication 1, comprenant les étapes suivantes :
former une couche diélectrique souple (106) en matériau à base de polymère sur une surface d'un substrat semi-conducteur (102), la couche diélectrique souple (106) comportant une pluralité d'orifices (210) s'étendant à travers elle, et chacun des orifices (210) exposant un plot d'entréelsortie différent (200) disposé sur la surface du substrat semi-conducteur (102) ;
former un corps souple électro-conducteur (220) dans chacun des orifices (210) de la couche diélectrique souple (106) de telle manière que chacun des corps souples (220) soit couplé électriquement au premier élément de revêtement métallique conducteur (240) exposé par l'orifice correspondant (210) ;
former un élément de revêtement métallique électro-conducteur (400) sur chacun des corps souples (220), de sorte que les éléments de revêtement métallique conducteur (240) recouvrent sensiblement les corps souples (220) et font office de couches d'adhérence, de couches d'arrêt ou à la fois de couches d'adhérence et d'arrêt :
former une couche diélectrique extérieure (108) sur la couche diélectrique souple (106), la couche diélectrique extérieure (108) comportant une pluralité d'orifices (230) s'étendant à travers elle, et chacun des orifices (230) exposant un élément de revêtement métallique conducteur (240) différent ; et
former un élément conducteur soudable, électro-conducteur (240) dans chacun des orifices (230) de la couche diélectrique extérieure (108), de telle manière que chacun des éléments conducteurs soudables (240) soit couplé électriquement à l'élément de revêtement métallique conducteur (400) exposé par l'orifice correspondant (230), et chacun des éléments conducteurs soudables (240) étant mouillable par le matériau de soudage.

41. Procédé selon la revendication 40, dans lequel la formation de l'élément de revêtement métallique électro-conducteur (400) sur chacun des corps souples (220) comprend les étapes suivantes :
former un élément de revêtement métallique électro-conducteur (400) sur chacun des corps souples (220), de sorte que les éléments de revêtement métallique conducteurs (400) recouvrent sensiblement les corps souples (220) et font office de couches d'adhérence, de couches d'arrêt ou à la fois de couches d'adhérence et d'arrêt, chacun des éléments de revêtement métallique conducteurs (400) comprenant au moins une couche d'un métal sélectionné parmi le groupe constitué de : chrome, cuivre, or, argent, titane, et tungstène.

42. Procédé selon la revendication 40, dans lequel la formation de l'élément conducteur soudable, électro-conducteur (240) dans chacun des orifices de la couche diélectrique extérieure (108) comprend les étapes suivantes:
former un élément conducteur soudable, électro-conducteur (240) dans chacun des orifices (230) de la couche diélectrique extérieure (108) de telle manière que chacun des éléments conducteurs soudables (240) soit couplé électriquement à l'élément de revêtement métallique conducteur (400) exposé par l'orifice correspondant (230), chacun des éléments conducteurs soudables (240) étant mouillable par le matériau de soudage, et chacun des éléments conducteurs soudables (240) comprenant au moins un métal sélectionné parmi un groupe constitué de : plomb, étain, cadmium, indium, bismuth, gallium, cuivre, argent, platine, palladium, nickel, et or.

43. Procédé de fabrication d'un dispositif à semi-conducteur (100) conforme à la revendication 1, comprenant les étapes suivantes :
former un premier élément de revêtement métallique électro-conducteur (300) sur chacun d'une pluralité de plots d'entrée/sortie (E/S) (200) disposés sur une surface d'un substrat semi-conducteur (102), dans lequel les contours extérieurs des éléments de revêtement métallique conducteurs (300) s'étendent au-delà des contours extérieurs des plots d'E/S correspondants (200), et dans lequel les éléments de revêtement métallique conducteurs (300) font office de couches d'adhérence, de couches d'arrêt ou à la fois de couches d'adhérence et d'arrêt ;
former une couche diélectrique souple (106) en matériau à base de polymère sur la surface du substrat semi-conducteur (102), la couche diélectrique souple (106) comportant une pluralité d'orifices (210) s'étendant à travers elle, et chacun des orifices (210) exposant un parmi les premiers éléments de revêtement métallique conducteurs (300) qui lui est propre ;
former un corps souple électro-conducteur (220) dans chacun des orifices (210) de la couche diélectrique souple (106) de telle manière que chacun des corps souples (220) soit couplé électriquement au premier élément de revêtement métallique conducteur (300) exposé par l'orifice correspondant (210) ;
former un second élément de revêtement métallique électro-conducteur (400) sur chacun des corps souples (220), les seconds éléments de revêtement métallique conducteurs (400) recouvrant sensiblement les corps souples (220) et faisant office de couches d'adhérence, de couches d'arrêt ou à la fois de couches d'adhérence et d'arrêt ;
former une couche diélectrique extérieure (108) sur le couche diélectrique souple (106), la couche diélectrique extérieure comportant une pluralité d'orifices (230) s'étendant à travers elle, et chacun des orifices (230) exposant un parmi les seconds éléments de revêtement métallique conducteurs (400) qui lui est propre ; et
former un élément conducteur soudable, électro-conducteur (240) dans chacun des orifices (230) de la couche diélectrique extérieure (108), de telle manière que chacun des éléments conducteurs soudables (240) soit couplé électriquement au second élément de revêtement métallique conducteur (400) exposé par l'orifice correspondant (230), chacun des éléments conducteurs soudables (240) étant mouillable par le matériau de soudage.

44. Procédé selon la revendication 43, dans lequel la formation du premier élément de revêtement métallique électro-conducteur (300) sur chacun de la pluralité de plots d'entrée/sortie (E/S) (200) comprend les étapes suivantes :
former un premier élément de revêtement métallique électro-conducteur (300) sur chacun d'une pluralité de plots d'entréelsortie (E/S) (200) disposés sur une surface d'un substrat semi-conducteur (102), de telle manière que les contours extérieurs des éléments de revêtement métallique conducteur (300) s'étendent au-delà des contours extérieurs des plots d'E/S correspondants (200), les premiers éléments de revêtement métallique conducteurs (300) faisant office de couches d'adhérence, de couches d'arrêt ou à la fois de couches d'adhérence et d'arrêt, chacun des premiers éléments de revêtement métallique conducteurs (300) comprenant au moins une couche d'un métal sélectionné parmi le groupe constitué de : chrome, cuivre, or, argent, titane, et tungstène.

45. Procédé selon la revendication 43, dans lequel la formation du second élément de revêtement métallique électro-conducteur (400) sur chacun des corps souples (220) comprend les étapes suivantes :
former un second élément de revêtement métallique électro-conducteur (400) sur chacun des corps souples (220), de telle manière que les seconds éléments de revêtement métallique conducteur (400) recouvrent sensiblement les corps souples (220) et font office de couches d'adhérence, de couches d'arrêt ou à la fois de couches d'adhérence et d'arrêt, et chacun des seconds éléments de revêtement métallique conducteurs (400) comprenant au moins une couche d'un métal sélectionné parmi le groupe constitué de : chrome, cuivre, or, argent, titane, et tungstène.

46. Procédé selon la revendication 43, dans lequel la formation de l'élément conducteur soudable, électro-conducteur (240) dans chacun des orifices (230) de la couche diélectrique extérieure (108) comprend les étapes suivantes :
former un élément conducteur soudable, électro-conducteur (240) dans chacun des orifices (230) de la couche diélectrique extérieure (108) de telle manière que chacun des éléments conducteurs soudables (240) soit couplé électriquement au second élément de revêtement métallique conducteur (400) exposé par l'orifice correspondant (230), chacun des éléments conducteurs soudables (240) étant mouillable par le matériau de soudage, et chacun des éléments conducteurs soudables (240) comprenant au moins un métal sélectionné parmi un groupe constitué de plomb, étain, cadmium, indium, bismuth, gallium, cuivre, argent, platine, palladium, nickel, et or.

47. Appareil (600) comprenant :
un composant constitué d'un substrat (602) et d'une pluralité de plots de liaison (604) disposés sur une surface (602A) du substrat (602), dans lequel les plots de liaison sont disposés selon un premier motif ;
un dispositif à semi-conducteur (100) selon l'une quelconque des revendications 1-33, dans lequel les plots d'E/S (220) sont disposés sur la surface du substrat semi-conducteur (102) selon un second motif, et dans lequel le second motif est sensiblement le même que le premier motif ; et
dans lequel les plots de liaison (604) du composant (600) sont adjacentes à et couplées électriquement aux plots d'E/S (200) du dispositif à semi-conducteur (100).

48. Appareil selon la revendication 47, dans lequel le dispositif à semi-conducteur (100) est un bottier-puce (CSP).

49. Appareil selon la revendication 47, dans lequel le substrat (602) du composant (600) est en matière plastique.

50. Appareil (600) selon la revendication 47, dans lequel le substrat (600) du composant est en céramique.

51. Appareil (600) selon la revendication 47, dans lequel le second motif est une image symétrique du premier motif.

52. Procédé de fabrication d'un appareil, comprenant les étapes suivantes :
procurer un élément constitué d'un substrat (602) et d'une pluralité de plots de liaison (604) disposées sur une surface (602A) du substrat (602), dans lequel les plots de liaison sont disposés selon un premier motif :
procurer un dispositif à semi-conducteur (100) selon l'une quelconque des revendications 1-33, dans lequel les plots d'E/S sont disposés sur la surface du substrat semi-conducteur (102) selon un second motif, et dans lequel le second motif est sensiblement le même que le premier motif ;
former une couche de revêtement de matériau de soudage (610) sur chacun des plots de liaison (604) du composant ;
amener les plots d'E/S (200) du dispositif à semi-conducteur (100) en contact avec les couches de revêtement de matériau de soudage (610) formées sur les plots de liaison (604) du composant ; et
chauffer le substrat (602) du composant sur le substrat à semi-conducteur (102) du dispositif à semi-conducteur (100) jusqu'à ce que les couches de revêtement de matériau de soudage fondent.

53. Procédé selon la revendication 52, dans lequel la réalisation du dispositif à semi-conducteur (100) comprend les étapes suivantes:
fournir un dispositif à semi-conducteur (100) comprenant :
un substrat semi-conducteur (102) et une pluralité de plots d'entrée/sortie (E/S) (200) disposés sur une surface (102A) du substrat semi-conducteur (102), dans lequel les plots d'E/S (200) sont disposés selon un second motif, et le second motif est une image symétrique du premier motif.

## Patentansprüche

1. Halbleitervorrichtung (100), umfassend
zahlreiche Anschlussflecke (200) für die Eingabe bzw. Ausgabe (I/O), die auf einer Oberfläche eines Halbleitersubstrats (102) angeordnet sind;
eine äußere dielektrische Schicht (108), die zahlreiche Öffnungen (230) aufweist, die sich durch sie hindurch erstrecken;
eine nachgiebige dielektrische Schicht (106), die zwischen der äußeren dielektrischen Schicht (108) und der Oberfläche (102A) des Halbleitersubstrats (102) angeordnet ist und zahlreiche Öffnungen (210) aufweist, die sich durch sie hindurch erstrecken, wobei die nachgiebige dielektrische Schicht (106) aus einem Material auf Polymerbasis besteht;
zahlreiche elektrisch leitende nachgiebige Höcker (104), wobei jeder nachgiebige Höcker (104) auf einem anderen I/O-Anschtussfleck (200) ausgebildet ist und zu diesem gehört, und wobei sich jeder nachgiebige Höcker (104) durch eine andere Öffnung (210, 230) in der nachgiebigen dielektrischen Schicht (106) und der äußeren dielektrischen Schicht (108) erstreckt, und worin jeder nachgiebige Höcker (104) umfasst:
ein elektrisch leitendes und lötbares Leiterelement (240), wobei das lötbare Leiterelement (240) mit Lot benetzbar ist; und
einen elektrisch leitenden nachgiebigen Körper (220), der zwischen dem lötbaren Leiterelement (240) und einem zugehörigen I/O-Anschlussfleck (200) angeordnet ist, wobei der nachgiebige Körper (220) das lötbare Leiterelement (240) elektrisch mit dem zugehörigen I/O-Anschlussfleck (200) verbindet.

2. Halbleitervorrichtung (100) nach Anspruch 1, wobei die Halbleitervorrichtung (100) ein Gehäuse in Chipgröße (CSP) ist.

3. Halbleitervorrichtung (100) nach Anspruch 1, wobei das lötbare Leiterelement (240) eines jeden nachgiebigen Höckers (104) mindestens ein Metall enthält, das ausgewählt wird aus der Gruppe mit: Blei, Zinn, Kadmium, Indium, Wismut, Gallium, Kupfer, Silber, Platin, Palladium, Nickel und Gold.

4. Halbleitervorrichtung (100) nach Anspruch 1, wobei das lötbare Leiterelement (240) eines jeden nachgiebigen Höckers (104) eine Legierung enthält, die mindestens zwei Metalle enthält, die ausgewählt werden aus der Gruppe mit: Blei, Zinn, Kadmium, Indium, Wismut und Gallium.

5. Halbleitervorrichtung (100) nach Anspruch 1, worin der nachgiebige Körper (220) eines jeden nachgiebigen Höckers (104) einen flexiblen elektrisch leitenden Weg zwischen dem lötbaren Leiterelement (240) und dem elektrischen Leiter bildet.

6. Halbleitervorrichtung (100) nach Anspruch 1, wobei sich eine Form eines jeden nachgiebigen Höckers (104) von einer ursprünglichen Form zu einer geänderten Form verändert, wenn der nachgiebige Höcker (104) einer Kraft ausgesetzt wird, die zwischen dem lötbaren Leiterelement (240) und dem elektrischen Leiter ausgeübt wird, und wobei die Form eines jeden nachgiebigen Höckers (104) im Wesentlichen in die ursprüngliche Form zurückkehrt, wenn die Kraft nicht mehr wirkt.

7. Halbleitervorrichtung (100) nach Anspruch 1, worin der nachgiebige Körper (220) eines jeden nachgiebigen Höckers (104) ein Material auf Polymerbasis enthält.

8. Halbleitervorrichtung (100) nach Anspruch 7, wobei das Material auf Polymerbasis Epoxid, Silikon, Polyimid, Acrylatpolymere oder Acrylatcopolymere enthält.

9. Halbleitervorrichtung (100) nach Anspruch 7, wobei der nachgiebige Körper (220) eines jeden nachgiebigen Höckers (104) zudem mindestens ein Füllmaterial enthält, das ausgewählt wird aus der Gruppe mit: Silber, Gold und Palladium, wobei zumindest ein Füllmaterial dazu verwendet wird, die elektrische Leitfähigkeit des nachgiebigen Körpers (220) zu erhöhen.

10. Halbleitervorrichtung (100) nach Anspruch 1, wobei der nachgiebige Körper (220) eines jeden nachgiebigen Höckers (104) einen spezifischen Volumenwiderstand von ungefähr 0,001 Ohm-cm oder weniger aufweist.

11. Halbleitervorrichtung (100) nach Anspruch 1, wobei der nachgiebige Körper (220) oder jeder nachgiebige Höcker (104) einen spezifischen Volumenwiderstand von ungefähr 0,0001 Ohm-cm oder weniger aufweist.

12. Halbleitervorrichtung (100) nach Anspruch 1, wobei der nachgiebige Körper (220) eines jeden nachgiebigen Höckers (104) einen Elastizitätsmodul von ungefähr 8000 MPa oder weniger aufweist.

13. Halbleitervorrichtung (100) nach Anspruch 1, wobei der nachgiebige Körper (220) eines jeden nachgiebigen Höckers (104) einen Elastizitätsmodul von ungefähr 1000 MPa oder weniger aufweist.

14. Halbleitervorrichtung (100) nach Anspruch 1, wobei jeder I/O-Anschlussfleck (200) dazu verwendet wird, elektrische Energie oder ein elektrisches Signal zu oder von der Halbleitervorrichtung (100) zu übertragen, und wobei die nachgiebigen Höcker (104) elektrische Anschlüsse der Halbleitervorrichtung (100) bilden.

15. Halbleitervorrichtung (100) nach Anspruch 1, wobei der nachgiebige Körper (220) eines bestimmten nachgiebigen Höckers (104) in direktem Kontakt mit dem zugehörigen I/O-Anschlussfleck (200) und dem lötbaren Leiterelement (240) des bestimmten nachgiebigen Höckers (104) steht.

16. Halbleitervorrichtung (100) nach Anspruch 1, wobei die Öffnungen (210, 230) in der nachgiebigen dielektrischen Schicht und der äußeren dielektrischen Schicht (108) den Positionen der I/O-Anschlussflecke (200) auf der Oberfläche des Halbleitersubstrats (102) entsprechen.

17. Halbleitervorrichtung (100) nach Anspruch 1, wobei die nachgiebige dielektrische Schicht (106) eine Spannungsentlastung für die äußere dielektrische Schicht (108) und die Oberfläche des Halbleitersubstrats (102) liefert.

18. Halbleitervorrichtung (100) nach Anspruch 1, wobei, wenn eine Kraft auf eine Oberfläche (108A, 108B) der äußeren dielektrischen Schicht (108) gegenüber der nachgiebigen dielektrischen Schicht (106) ausgeübt wird, die Kraft im Wesentlichen auf die nachgiebige dielektrische Schicht (106) übertragen wird, und wobei sich die nachgiebige dielektrische Schicht (106) als Reaktion auf die Kraft verformt, wodurch sich die äußere dielektrische Schicht (108) bezüglich der Oberfläche des Halbleitersubstrats (102) bewegen kann.

19. Halbleitervorrichtung (100) nach Anspruch 1, wobei das Material auf Polymerbasis Epoxid, Silikon, Polyimid, Acrylatpolymere oder Acrylatcopolymere enthält.

20. Halbleitervorrichtung (100) nach Anspruch 1, wobei die nachgiebige dielektrische Schicht (106) einen spezifischen Volumenwiderstand von ungefähr 1,0 x 10¹⁰ Ohm-cm oder mehr aufweist.

21. Halbleitervorrichtung (100) nach Anspruch 1, wobei die nachgiebige dielektrische Schicht (106) einen spezifischen Volumenwiderstand von ungefähr 1,0 x 10¹⁵ Ohm-cm oder mehr aufweist.

22. Halbleitervorrichtung (100) nach Anspruch 1, wobei die nachgiebige dielektrische Schicht (106) einen Elastizitätsmodul von ungefähr 8000 MPa oder weniger aufweist.

23. Halbleitervorrichtung (100) nach Anspruch 1, wobei die nachgiebige dielektrische Schicht (106) einen Elastizitätsmodul von ungefähr 1000 MPa oder weniger aufweist.

24. Halbleitervorrichtung (100) nach Anspruch 1, wobei die äußere dielektrische Schicht (108) einen mechanischen Schutz für die nachgiebige dielektrische Schicht (106) und die Oberfläche des Halbleitersubstrats (102) bietet.

25. Halbleitervorrichtung (100) nach Anspruch 1, wobei sich, wenn eine Kraft auf die Oberfläche der äußeren dielektrischen Schicht (108) gegenüber der nachgiebigen dielektrischen Schicht (106) ausgeübt wird, die äußere dielektrische Schicht (108) in geringerem Umfang verformt als die nachgiebige dielektrische Schicht (106), und dazu dient, die Kraft über eine relativ große Fläche der nachgiebigen dielektrischen Schicht (106) zu verteilen.

26. Halbleitervorrichtung (100) nach Anspruch 1, wobei die äußere dielektrische Schicht (108) ein Material auf Polymerbasis enthält.

27. Halbleltervorrichtung (100) nach Anspruch 26, wobei das Material auf Polymerbasis Epoxid, Silikon, Polyimid, Acrylatpolymere oder Acrylatcopolymere enthält.

28. Halbleitervorrichtung (100) nach Anspruch 1, wobei die äußere dielektrische Schicht (108) ein anorganisches dielektrisches Material enthält.

29. Halbleitervorrichtung (100) nach Anspruch 28, wobei das anorganische dielektrische Material ausgewählt wird aus der Gruppe mit Siliciumdioxid (SiO₂) und Siliciumnitrid (Si₃N₄).

30. Halbleitervorrichtung (100) nach Anspruch 1, wobei die äußere dielektrische Schicht (108) einen spezifischen Volumenwiderstand von ungefähr 1,0 x 10¹⁰ Ohm-cm oder mehr aufweist.

31. Halbleitervorrichtung (100) nach Anspruch 1, wobei die äußere dielektrische Schicht (108) einen spezifischen Volumenwiderstand von ungefähr 1,0 x 10¹⁵ Ohm-cm oder mehr aufweist.

32. Halbleitervorrichtung (100) nach Anspruch 1, wobei die äußere dielektrische Schicht (108) einen Elastizitätsmodul aufweist, der größer ist als der Elastizitätsmodul der nachgiebigen dielektrischen Schicht.

33. Halbleitervorrichtung (100) nach Anspruch 1, wobei die äußere dielektrische Schicht (108) einen Elastizitätsmodul aufweist, der mindestens doppelt so groß ist wie der Elastizitätsmodul der nachgiebigen dielektrischen Schicht.

34. Verfahren zum Ausbilden einer Halbleitervorrichtung (100) nach Anspruch 1, umfassend das Ausbilden einer nachgiebigen dielektrischen Schicht (106), die aus einem Material auf Polymerbasis besteht, über einer Oberfläche eines Halbleitersubstrats (102), wobei zahlreiche Anschlussflecke (200) für die Eingabe bzw. Ausgabe (I/O) auf der Oberfläche des Halbleitersubstrats (102) angeordnet sind, und wobei die nachgiebige dielektrische Schicht (106) zahlreiche Öffnungen (210) aufweist, die sich durch sie hindurch erstrecken, und wobei jede der Öffnungen (230) einen anderen I/O-Anschlussfleck (200) freilegt;
das Ausbilden eines elektrisch leitenden nachgiebigen Körpers (220) in jeder Öffnung (210) der nachgiebigen dielektrischen Schicht (106), so dass jeder der nachgiebigen Körper (220) elektrisch mit dem I/O-Anschlussfleck (200) verbunden ist, den die zugehörige Öffnung (210) freilegt;
das Ausbilden einer äußeren dielektrischen Schicht (108) über der nachgiebigen dielektrischen Schicht (106), wobei die äußere dielektrische Schicht (108) zahlreiche Öffnungen (230) aufweist, die sich durch sie hindurch erstrecken, und worin jede Öffnung (230) einen anderen nachgiebigen Körper (220) freilegt: und
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem nachgiebigen Körper (220) verbunden ist, den die zugehörige Öffnung freilegt, und worin jedes lötbare Leiterelement (240) mit Lot benetzbar ist.

35. Verfahren nach Anspruch 34, wobei das Ausbilden des elektrisch leitenden Körpers (220) in jeder Öffnung der nachgiebigen dielektrischen Schicht (106) umfasst:
das Ausbilden eines elektrisch leitenden nachgiebigen Körpers (220) in jeder Öffnung (210) der nachgiebigen dielektrischen Schicht (106), so dass eine untere Fläche (220B) eines jeden nachgiebigen Körpers (220) in direktem Kontakt mit einer oberen Fläche (200A) des I/O-Anschlussflecks (200) steht, den die zugehörige Öffnung (210) freilegt, und **dadurch** elektrisch mit dem I/O-Anschlussfleck (200) verbunden ist, den die zugehörige Öffnung (210) freilegt.

36. Verfahren nach Anspruch 34, wobei das Ausbilden des elektrisch leitenden lötbaren Leiterelements (240) in jeder Öffnung (230) der äußeren dielektrischen Schicht (108) umfasst:
das Ausbilden eines elektrisch leitenden lötbaren Leiterelements (240) in jeder Öffnung (230) der äußeren dielektrischen Schicht (108), so dass eine untere Fläche (240B) eines jeden lötbaren Leiterelements (240) in direktem Kontakt mit einer oberen Fläche (220A) des nachgiebigen Körpers (220) steht, den die zugehörige Öffnung freilegt, und **dadurch** elektrisch mit dem nachgiebigen Körper (220) verbunden ist, den die zugehörige Öffnung (230) freilegt, und wobei jedes lötbare Leiterelement (240) mindestens ein Metall enthält, das ausgewählt wird aus der Gruppe mit Blei, Zinn, Kadmium, Indium, Wismut, Gallium, Kupfer, Silber, Platin, Palladium, Nickel und Gold.

37. Verfahren zum Ausbilden einer Halbleitervorrichtung (100) nach Anspruch 1, umfassend das Ausbilden eines elektrisch leitenden Metallbeschichtungselements (300) über jedem der zahlreichen Anschlussflecke (200) für die Eingabe bzw. Ausgabe (I/O), die auf einer Oberfläche eines Halbleitersubstrats (102) angeordnet sind, wobei sich die äußeren Begrenzungen des Metallbeschichtungselements (300) über die äußeren Begrenzungen der zugehörigen I/O-Anschlussflecke (200) hinaus erstrecken, und worin die leitenden Metallbeschichtungselemente (300) als Adhäsionsschichten, als Sperrschichten oder sowohl als Adhäsionsschichten als auch als Sperrschichten wirken;
das Ausbilden einer nachgiebigen dielektrischen Schicht (106), die aus einem Material auf Polymerbasis besteht, auf der Oberfläche des Halbleitersubstrats (102), wobei die nachgiebige dielektrische Schicht (106) zahlreiche Öffnungen (230) aufweist, die sich durch sie hindurch erstrecken, und wobei jede Öffnung (230) ein anderes leitendes Metallbeschichtungselement (300) freilegt;
das Ausbilden eines elektrisch leitenden nachgiebigen Körpers (220) in jeder Öffnung der nachgiebigen dielektrischen Schicht (106), so dass jeder nachgiebige Körper (220) elektrisch mit dem leitenden Metallbeschichtungselement (300) verbunden ist, das die zugehörige Öffnung (210) freilegt;
das Ausbilden einer dielektrischen Schicht (108) über der nachgiebigen dielektrischen Schicht (106), wobei die äußere dielektrische Schicht (108) zahlreiche Öffnungen (230) aufweist, die sich durch sie hindurch erstrecken, und wobei jede Öffnung (230) einen anderen nachgiebigen Körper (220) freilegt; und
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem nachgiebigen Körper (220) verbunden ist, den die zugehörige Öffnung (230) freilegt, und wobei jedes lötbare Leiterelement (240) mit Lot benetzbar ist.

38. Verfahren nach Anspruch 37, wobei das Ausbilden des elektrisch leitenden Metallbeschichtungselements (300) über jedem der zahlreichen Anschlussflecke (200) für die Eingabe bzw. Ausgabe (I/O) umfasst:
das Ausbilden eines elektrisch leitenden Metallbeschichtungselements (300) über jedem der zahlreichen Anschlussflecke (200) für die Eingabe bzw. Ausgabe (I/O), die auf einer Oberfläche eines Halbleitersubstrats (102) angeordnet sind, wobei sich die äußeren Begrenzungen der leitenden Metallbeschichtungselemente (300) über die äußeren Begrenzungen der zugehörigen I/O-Anschlussflecke (200) hinaus erstrecken, und worin die leitenden Metallbeschichtungselemente (300) als Adhäsionsschichten, als Sperrschichten oder sowohl als Adhäsionsschichten als auch als Sperrschichten wirken, und worin jedes leitende Metallbeschichtungselement (300) mindestens eine Schicht aus einem Metall enthält, das ausgewählt wird aus der Gruppe mit Chrom, Kupfer, Gold, Silber, Titan und Wolfram.

39. Verfahren nach Anspruch 37, wobei das Ausbilden des elektrisch leitenden lötbaren Leiterelements (240) in jeder Öffnung (230) der äußeren dielektrischen Schicht (108) umfasst:
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem nachgiebigen Körper (220) verbunden ist, den die zugehörige Öffnung (230) freilegt, und wobei jedes lötbare Leiterelement (240) mit Lot benetzbar ist, und worin jedes lötbare Leiterelement (240) mindestens ein Metall enthält, das ausgewählt wird aus der Gruppe mit Blei, Zinn, Kadmium, Indium, Wismut, Gallium, Kupfer, Silber, Platin, Palladium, Nickel und Gold.

40. Verfahren zum Ausbilden einer Halbleitervorrichtung (100) nach Anspruch 1, umfassend das Ausbilden einer nachgiebigen dielektrischen Schicht (106), die aus einem Material auf Polymerbasis besteht, über einer Oberfläche eines Halbleitersubstrats (102), wobei die nachgiebige dielektrische Schicht (106) zahlreiche Öffnungen (210) aufweist, die sich durch sie hindurch erstrecken, und wobei jede Öffnung (210) einen anderen der zahlreichen Anschlussflecke (200) für die Eingabe bzw. Ausgabe (I/O) freilegt, die auf der Oberfläche des Halbleitersubstrats (102) angeordnet sind;
das Ausbilden eines elektrisch leitenden nachgiebigen Körpers (220) in jeder Öffnung (210) der nachgiebigen dielektrischen Schicht (106), so dass jeder nachgiebige Körper (220) elektrisch mit dem ersten leitenden Metallbeschichtungselement (240) verbunden ist, das die zugehörige Öffnung (210) freilegt;
das Ausbilden eines elektrisch leitenden Metallbeschichtungselements (400) über jedem nachgiebigen Körper (220), wobei die leitenden Metallbeschichtungselemente (240) im Wesentlichen die nachgiebigen Körper (220) bedecken und als Adhäsionsschichten, als Sperrschichten oder sowohl als Adhäsionsschichten als auch als Sperrschichten wirken;
das Ausbilden einer äußeren dielektrischen Schicht (108) über der nachgiebigen dielektrischen Schicht (106), wobei die äußere dielektrische Schicht (108) zahlreiche Öffnungen (230) aufweist, die sich durch sie hindurch erstrecken, und wobei jede Öffnung (230) ein anderes leitendes Metallbeschichtungselement (240) freilegt; und
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem leitenden Metallbeschichtungselement (400) verbunden ist, das die zugehörige Öffnung (230) freilegt, und wobei jedes lötbare Leiterelement (240) mit Lot benetzbar ist.

41. Verfahren nach Anspruch 40, wobei das Ausbilden des elektrisch leitenden Metallbeschichtungselements (400) über jedem nachgiebigen Körper (220) umfasst:
das Ausbilden eines elektrisch leitenden Metallbeschichtungselements (400) über jedem nachgiebigen Körper (220), wobei die leitenden Metallbeschichtungselemente (400) die nachgiebigen Körper (220) im Wesentlichen bedecken und als Adhäsionsschichten, als Sperrschichten oder sowohl als Adhäsionsschichten als auch als Sperrschichten wirken, und worin jedes leitende Metallbeschichtungselement (400) mindestens eine Schicht aus einem Metall enthält, das ausgewählt wird aus der Gruppe mit Chrom, Kupfer, Gold, Silber, Titan und Wolfram.

42. Verfahren nach Anspruch 40, wobei das Ausbilden des elektrisch leitenden lötbaren Leiterelements (240) in jeder Öffnung der äußeren dielektrischen Schicht (108) umfasst:
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem leitenden Metallbeschichtungselement (400) verbunden ist, das die zugehörige Öffnung (230) freilegt, und worin jedes lötbare Leiterelement (240) mit Lot benetzbar ist, und wobei jedes lötbare Leiterelement (240) mindestens ein Metall enthält, das ausgewählt wird aus der Gruppe mit: Blei, Zinn, Kadmium, Indium, Wismut, Gallium, Kupfer, Silber, Platin, Palladium, Nickel und Gold.

43. Verfahren zum Ausbilden einer Halbleitervorrichtung (100) nach Anspruch 1, umfassend das Ausbilden eines ersten elektrisch leitenden Metallbeschichtungselements (300) über jedem der zahlreichen Anschlussflecke (200) für die Eingabe bzw. Ausgabe (I/O), die auf einer Oberfläche eines Halbleitersubstrats (102) angeordnet sind, wobei sich die äußeren Begrenzungen der leitenden Metallbeschichtungselemente (300) über die äußeren Begrenzungen der zugehörigen I/O-Anschlussflecke (200) hinaus erstrecken, und worin die leitenden Metallbeschichtungselemente (300) als Adhäsionsschichten, als Sperrschichten oder sowohl als Adhäsionsschichten als auch als Sperrschichten wirken;
das Ausbilden einer nachgiebigen dielektrischen Schicht (106), die aus einem Material auf Polymerbasis besteht, auf der Oberfläche des Halbleitersubstrats (102), wobei die nachgiebige dielektrische Schicht (106) zahlreiche Öffnungen (210) aufweist, die sich durch sie hindurch erstrecken, und wobei jede Öffnung (210) ein anderes erstes leitendes Metallbeschichtungselement (300) freilegt;
das Ausbilden eines elektrisch leitenden nachgiebigen Körpers (220) in jeder Öffnung (210) der nachgiebigen dielektrischen Schicht (106), so dass jeder nachgiebige Körper (220) elektrisch mit dem ersten leitenden Metallbeschichtungselement (300) verbunden ist, das die zugehörige Öffnung (210) freilegt;
das Ausbilden eines zweiten elektrisch leitenden Metallbeschichtungselements (400) über jedem nachgiebigen Körper (220), wobei die zweiten leitenden Metallbeschichtungselemente (400) die nachgiebigen Körper (220) im Wesentlichen bedecken und als Adhäsionsschichten, als Sperrschichten oder sowohl als Adhäsionsschichten als auch als Sperrschichten wirken;
das Ausbilden einer äußeren dielektrischen Schicht (108) über der nachgiebigen dielektrischen Schicht (106), wobei die äußere dielektrische Schicht zahlreiche Öffnungen (230) aufweist, die sich durch sie hindurch erstrecken, und wobei jede Öffnung (230) ein anderes zweites leitendes Metallbeschichtungselement (400) freilegt; und
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem zweiten leitenden Metallbeschichtungselement (400) verbunden ist, das die zugehörige Öffnung (230) freilegt, und wobei jedes lötbare Leiterelement (240) mit Lot benetzbar ist.

44. Verfahren nach Anspruch 43, wobei das Ausbilden des ersten elektrisch leitenden Metallbeschichtungselements (300) über jedem der zahlreichen Anschlussflecke (200) für die Eingabe bzw. Ausgabe (I/O) umfasst:
das Ausbilden eines ersten elektrisch leitenden Metallbeschichtungselements (300) über jedem der zahlreichen Anschlussflecke (200) für die Eingabe bzw. Ausgabe (I/O), die auf einer Oberfläche eines Halbleitersubstrats (102) angeordnet sind, wobei sich die äußeren Begrenzungen der leitenden Metallbeschichtungselemente (300) über die äußeren Begrenzungen der zugehörigen I/O-Anschlussflecke (200) hinaus erstrecken, und worin die ersten leitenden Metallbeschichtungselemente (300) als Adhäsionsschichten, als Sperrschichten oder sowohl als Adhäsionsschichten als auch als Sperrschichten wirken, und worin jedes erste leitende Metallbeschichtungselement (300) mindestens ein Metall enthält, das ausgewählt wird aus der Gruppe mit Chrom, Kupfer, Gold, Silber, Titan und Wolfram.

45. Verfahren nach Anspruch 43, wobei das Ausbilden des zweiten elektrisch leitenden Metallbeschichtungselements (400) über jedem nachgiebigen Körper (220) umfasst:
das Ausbilden eines zweiten elektrisch leitenden Metallbeschichtungselements (400) über jedem nachgiebigen Körper (220), wobei die zweiten leitenden Metallbeschichtungselemente (400) die nachgiebigen Körper (220) im Wesentlichen bedecken und als Adhäsionsschichten, als Sperrschichten oder sowohl als Adhäsionsschichten als auch als Sperrschichten wirken, und worin jedes zweite leitende Metallbeschichtungselement (400) mindestens eine Schicht aus Metall enthält, das ausgewählt wird aus der Gruppe mit Chrom, Kupfer, Gold, Silber, Titan und Wolfram.

46. Verfahren nach Anspruch 43, wobei das Ausbilden des elektrisch leitenden lötberen Leiterelements (240) in jeder Öffnung (230) der äußeren dielektrischen Schicht (108) umfasst:
das Ausbilden eines elektrisch leitenden lötbaren Leiterelements (240) in jeder Öffnung (230) der äußeren dielektrischen Schicht (108), so dass jedes lötbare Leiterelement (240) elektrisch mit dem zweiten leitenden Metallbeschichtungselement (400) verbunden ist, das die zugehörige Öffnung (230) freilegt, und wobei jedes lötbare Leiterelement (240) mit Lot benetzbar ist, und worin jedes lötbare Leiterelement (240) mindestens ein Metall enthält, das ausgewählt wird aus der Gruppe mit: Blei, Zinn, Kadmium, Indium, Wismut, Gallium, Kupfer, Silber, Platin, Palladium, Nickel und Gold.

47. Einrichtung (600), umfassend eine Komponente, die ein Substrat (602) und zahlreiche Bond-Anschlussflecke (604) enthält, die auf einer Oberfläche (602A) des Substrats (602) angeordnet sind, wobei die Bond-Anschlussflecke in einem ersten Muster angeordnet sind;
eine Halbleitervorrichtung (100) nach irgendeinem der Ansprüche 1 - 33, wobei die I/O-Anschlussflecke (200) auf der Oberfläche des Halbleitersubstrats (102) in einem zweiten Muster angeordnet sind, und wobei das zweite Muster im Wesentlichen dem ersten Muster gleicht; und
worin die Bond-Anschlussflecke (604) der Komponente (600) benachbart zu den I/O-Anschlussflecken (200) der Halbleitervorrichtung (100) angeordnet und elektrisch damit verbunden sind.

48. Einrichtung nach Anspruch 47, wobei die Halbleitervorrichtung (100) ein Gehäuse in Chipgröße (CSP) ist.

49. Einrichtung nach Anspruch 47, wobei das Substrat (602) der Komponente (600) ein Kunststoffmaterial enthält.

50. Einrichtung (600) nach Anspruch 47, wobei das Substrat (602) der Komponente ein Keramikmaterial enthält.

51. Einrichtung (600) nach Anspruch 47, wobei das zweite Muster ein Spiegelbild des ersten Musters ist.

52. Verfahren zum Ausbilden einer Einrichtung, umfassend das Bereitstellen einer Komponente, die ein Substrat (602) und zahlreiche Bond-Anschlussflecke (604) enthält, die auf einer Oberfläche (602A) des Substrats (602) angeordnet sind, wobei die Bond-Anschlussflecke in einem ersten Muster angeordnet sind;
das Bereitstellen einer Halbleitervorrichtung (100) gemäß irgendeinem der Ansprüche 1 - 33, wobei die I/O-Anschlussflecke auf der Oberfläche des Halbleitersubstrats (102) in einem zweiten Muster angeordnet sind, und wobei das zweite Muster im Wesentlichen dem ersten Muster gleicht;
das Ausbilden einer Lötüberzugsschicht (610) auf jedem Bond-Anschlussfleck (604) der Komponente;
das In-Berührung-Bringen der I/O-Anschlussflecke (200) der Halbleitervorrichtung (100) mit den Lötüberzugsschichten (610), die auf den Bond-Anschlussflecken (604) der Komponente ausgebildet sind; und
das Erwärmen des Substrats (602) der Komponente oder des Halbleitersubstrats (102) der Halbleitervorrichtung (100), bis die Lötüberzugsschichten schmelzen.

53. Verfahren nach Anspruch 52, wobei das Bereitstellen der Halbleitervorrichtung (100) umfasst: das Bereitstellen einer Halbleitervorrichtung (100), umfassend ein Halbleitersubstrat (102) und zahlreiche Anschlussflecke (200) für die. Eingabe bzw. Ausgabe (I/O), die auf einer Oberfläche (102A) des Halbleitersubstrats (102) angeordnet sind, wobei die I/O-Anschlussflecke (200) in einem zweiten Muster angeordnet sind, und wobei das zweite Muster ein Spiegelbild des ersten Musters ist.
